# EUROPEAN PATENT APPLICATION

(11) **EP 4 254 529 A1**
(43) Date of publication of application: **04.10.2023**
(21) Application number: 21898327.8
(22) Date of filing: 01.10.2021
(51) Int. Cl.: H01L 51/44, H01L 51/42, C07F 7/24, H01L 51/00

(54) **PEROVSKITE SOLAR CELL MODULE AND MANUFACTURING METHOD FOR SAME**

(30) Priority: 25.11.2020 KR 20200159793
(71) Applicant: Unitest Inc., Gyeonggi-do 17099 (KR)
(72) Inventor: YU, Jong Su, Daejeon 34120 (KR); NOH, Yong-Jin, Sejong 30124 (KR); KIM, Juae, Daejeon 34017 (KR); LEE, Byung-Woo, Suwon-si Gyeonggi-do 16319 (KR); HUH, Jae-Suk, Yongin-si Gyeonggi-do 16807 (KR)
(74) Representative: De Vries & Metman
(86) International application number: PCT/KR2021/013543
(87) International publication number: WO 2022/114501

(57) **Abstract**

The present invention relates to a perovskite solar cell module and a manufacturing method for same. The perovskite solar cell module comprises a plurality of perovskite solar cells disposed on a substrate, each of the perovskite solar cells comprising: a first electrode, a first charge transport layer on the first electrode, an optical active layer formed of a perovskite crystal structure, and a second charge transport layer, which are laminated in this order; and a second electrode laminated on the second charge transport layer, wherein the second electrode included in each of the cells can be electrically connected in series to the first electrode of the closest perovskite solar cell and enhance the photoelectric conversion efficiency of the perovskite solar cell module.

## Description

### Technical Field

The present disclosure relates generally to a perovskite solar cell module and a manufacturing method for the same and, more particularly, to a perovskite solar cell module and a manufacturing method for the same capable of improving the reliability of the perovskite solar cell module.

### Background Art

Perovskite is a semiconductor material with a special hexagonal structure, and has the property of converting light into electricity (photoelectric conversion) or electricity into light (luminescence). Due to its low production cost and high efficiency, perovskite is attracting attention as a next-generation solar cell material. Solar cells are a renewable and eco-friendly source of energy, and are considered as a prominent energy source that can solve the problems of limited reserves and environmental pollution caused by conventional fossil fuels.

Among these, perovskite solar cells are under active development because they can realize high efficiency at a lower cost than conventional silicon solar cells. Despite high light conversion efficiency, the voltage and current values that can be obtained from one small perovskite solar cell are limited, and it is difficult to apply it for power generation to commonly used mobile phones or LED electronic devices. For this reason, large-area modularization is essential for commercialization of perovskite. However, increasing the area of the solar cell results in an increase in sheet resistance and consequently a reduction in efficiency, which is problematic.

Therefore, in order to produce practically usable power, modularization has to be achieved by connecting a plurality of small-sized solar cells.

However, due to inherent nature of perovskite, when moisture and oxygen permeate into perovskite, the crystal structure of perovskite is deformed. This may cause deformation and damage to the interface of the solar cell, resulting in deterioration in performance.

In order to overcome the problems associated with modularization of conventional perovskite solar cells, there is an urgent need for various perovskite solar cell modules capable of effectively blocking external moisture and oxygen while minimizing contact resistance and interfacial resistance caused by series connection of small solar cells constituting the module.

### Disclosure

### Technical Problem

Accordingly, the present disclosure has been made keeping in mind the above problems occurring in the related art, and an objective of the present disclosure is to provide a perovskite solar cell module capable of improving module stability by blocking permeation of external moisture and oxygen into the module and preventing performance degradation by minimizing contact resistance and interfacial resistance caused by series connection of small solar cells, and to provide a manufacturing method for the same.

### Technical Solution

In order to accomplish the above objective, the present disclosure provides a perovskite solar cell module including a plurality of perovskite solar cells disposed on a substrate. Each of the perovskite solar cells may include: a first electrode; a first charge transport layer stacked on the first electrode; a photoactive layer stacked on the first charge transport layer and made of a perovskite material; a second charge transport layer stacked on the photoactive layer; and a second electrode stacked on the second charge transport layer,

Here, the second electrode of each cell may be electrically connected in series to the first electrode of a nearest cell.

Preferably, the second electrode of each cell may be stacked on an upper surface of the second charge transport layer and in contact with the first electrode of the nearest cell, and be patterned to be separated from the second electrode of the nearest cell.

Preferably, each cell may further include a functional layer stacked on at least one of positons between the second charge transport layer and the second electrode thereof, and between first charge transport layers, photoactive layers, and second charge transport layers patterned and separated so that the second electrode of each cell is in contact with the first electrode of the nearest cell, the functional layer being configured to block permeation of external moisture and oxygen.

Preferably, each cell may further include a functional layer stacked on at least one of an upper surface of the second electrode thereof and between the second electrodes patterned and separated in neighboring cells.

Preferably, the second electrode of each cell may be stacked on the upper surface of the second charge transport layer and in contact with the first electrode of the nearest cell, and the first charge transport layer, the photoactive layer, the second charge transport layer, the functional layer, and the second electrode of each cell may be patterned on the first electrode by etching to be separated from the first charge transport layer, the photoactive layer, the second charge transport layer, the functional layer, and the second electrode of the nearest cell.

Preferably, each cell may further include a functional layer stacked on at least one of an upper surface of the second electrode thereof and between the first charge transport layers, the photoactive layers, the second charge transport layers, the functional layers, and the second electrodes patterned and separated in neighboring cells.

Preferably, each cell may further include a functional layer stacked on at least one of an upper surface of the second electrode thereof and between the second electrodes patterned and separated in neighboring cells.

Preferably, the second electrode of each cell may be stacked on the upper surface of the second charge transport layer and in contact with the first electrode of the nearest cell, and the first charge transport layer, the photoactive layer, the second charge transport layer, and the second electrode of each cell may be patterned on the first electrode by etching to be separated from the first charge transport layer, the photoactive layer, the second charge transport layer, and the second electrode of the nearest cell.

Preferably, each cell may further include a functional layer stacked on at least one of an upper surface of the second electrode thereof and between the first charge transport layers, the photoactive layers, the second charge transport layers, and the second electrodes patterned and separated in neighboring cells.

According to another aspect of the present disclosure, there is provided a method of manufacturing a perovskite solar cell module in which a plurality of perovskite solar cells are disposed on a substrate.

The method may include a first pattern forming step of sequentially stacking a first electrode, a first charge transport layer, a photoactive layer, and a second charge transport layer on the substrate, and patterning the first charge transport layer, the photoactive layer, and the second charge transport layer to separate each of the layers with predetermined spaces formed therein so that a second electrode of each cell is in contact with the first electrode of a nearest cell.

The method may further include a second pattern forming step of stacking a functional layer on an upper surface of the second charge transport layer of each cell and between the second charge transport layer and the second electrode of each cell, and partially patterning the functional layer to form predetermined spaces therein so that the second electrode of each cell is electrically connected in series to the first electrode of the nearest cell.

Preferably, the method may further include a third pattern forming step of patterning the second electrode to form predetermined spaces therein so that the second electrode of each cell is separated from the second electrode of the nearest cell.

According to another aspect of the present disclosure, there is provided a perovskite solar cell module including: a substrate; first electrodes formed to be spaced apart from each other on an upper surface of the substrate, or stacked on the upper surface of the substrate and patterned to be separated with predetermined spaces formed therein; a first charge transport layer stacked on an upper surface of the first electrode and patterned to be separated with predetermined spaces formed therein; a photoactive layer stacked on an upper surface of the first charge transport layer and patterned to be separated with predetermined spaces formed therein; a second charge transport layer stacked on an upper surface of the photoactive layer and patterned to be separated with predetermined spaces formed therein; a functional layer stacked on an upper surface of the second charge transport layer and between the separated first charge transport layers, the separated photoactive layers, and the separated second charge transport layers, the functional layer being configured to reduce interfacial resistance and block permeation of external moisture and oxygen; and a second electrode formed on an upper surface of the functional layer and patterned to be separated with predetermined spaces formed therein.

Preferably, each of the separated second electrodes may be formed adjacent to or in contact with an adjacent first electrode and be electrically connected to the adjacent first electrode.

Preferably, the functional layer may be formed on a surface of each of the separated second electrodes and be stacked at least between the separated second electrodes.

Preferably, the first charge transport layer, the photoactive layer, the second charge transport layer, the functional layer, and the second electrode may be patterned on the first electrodes to be separated with predetermined spaces formed therein.

Preferably, the functional layer may be formed between the separated first charge transport layers, the separated photoactive layers, the separated second charge transport layers, the separated functional layers, and the separated second electrodes.

According to another aspect of the present disclosure, there is provided a perovskite solar cell module including: a substrate; first electrodes formed to be spaced apart from each other on an upper surface of the substrate, or stacked on the upper surface of the substrate and patterned to be separated with predetermined spaces formed therein; a first charge transport layer stacked on an upper surface of the first electrode and patterned to be separated with predetermined spaces formed therein; a photoactive layer stacked on an upper surface of the first charge transport layer and patterned to be separated with predetermined spaces formed therein; a second charge transport layer stacked on an upper surface of the photoactive layer and patterned to be separated with predetermined spaces formed therein; a functional layer stacked between the separated first charge transport layers, the separated photoactive layers, and the separated second charge transport layers, the functional layer being configured to reduce interfacial resistance and block permeation of external moisture and oxygen; and a second electrode formed on an upper surface of the second charge transport layer and an upper surface of the functional layer and patterned to be separated with predetermined spaces formed therein.

Preferably, each of the separated second electrodes may be formed adjacent to or in contact with an adjacent first electrode and be electrically connected to the adjacent first electrode.

Preferably, the functional layer may be formed on a surface of each of the separated second electrodes and be stacked at least between the separated second electrodes.

Preferably, the first charge transport layer, the photoactive layer, the second charge transport layer, the functional layer, and the second electrode may be patterned on the first electrodes to be separated with predetermined spaces formed therein.

Preferably, the functional layer may be formed between the separated first charge transport layers, the separated photoactive layers, the separated second charge transport layers, the separated functional layers, and the separated second electrodes.

According to another aspect of the present disclosure, there is provided a perovskite solar cell module including: a substrate; first electrodes formed to be spaced apart from each other on an upper surface of the substrate, or stacked on the upper surface of the substrate and patterned to be separated with predetermined spaces formed therein; a first charge transport layer stacked on an upper surface of the first electrode and patterned to be separated with predetermined spaces formed therein; a photoactive layer stacked on an upper surface of the first charge transport layer and patterned to be separated with predetermined spaces formed therein; a second charge transport layer stacked on an upper surface of the photoactive layer and patterned to be separated with predetermined spaces formed therein; a second electrode stacked on an upper surface of the second charge transport layer and between the separated first charge transport layers, the separated photoactive layers, and the separated second charge transport layers, and patterned to be separated with predetermined spaced formed therein; and a functional layer formed on a surface of each of the separated second electrodes and stacked at least between the separated second electrodes, and configured to reduce interfacial resistance and block permeation of external moisture and oxygen.

Preferably, each of the separated second electrodes may be formed adjacent to or in contact with an adjacent first electrode and be electrically connected to the adjacent first electrode.

Preferably, the first charge transport layer, the photoactive layer, the second charge transport layer, the functional layer, and the second electrode may be patterned on the first electrodes to be separated with predetermined spaces formed therein.

Preferably, the functional layer may be formed on a surface of each of the separated second electrodes, and be stacked at least between the separated first charge transport layers, the separated photoactive layers, the separated second charge transport layers, the separated functional layers, and the separated second electrodes.

### Advantageous Effects

According to the present disclosure, in a perovskite solar cell module including a substrate, a first electrode, a first charge transport layer, a photoactive layer, a second charge transport layer, and a second electrode, by stacking a functional layer in predetermined spaces between separated first charge transport layers, separated photoactive layers, and separated second charge transport layers patterned on separated first electrodes, it is possible to prevent penetration of external moisture and oxygen and reduce interfacial resistance and contact resistance caused by electric connection, thereby improving photoelectric conversion efficiency.

### Description of Drawings

FIG. 1 is a schematic view illustrating a manufacturing sequence of a perovskite solar cell module according to an embodiment.
FIG. 2 is a schematic view illustrating a perovskite solar cell module according to a first embodiment.
FIGS. 3 to 13 are views illustrating other examples of the perovskite solar cell module according to the first embodiment.
FIG. 14 is a schematic view illustrating a perovskite solar cell module according to a second embodiment.
FIGS. 15 to 25 are views illustrating other examples of the perovskite solar cell module according to the second embodiment.
FIG. 26 is a schematic view illustrating a perovskite solar cell module according to a third embodiment.
FIGS. 27 to 37 are views illustrating other examples of the perovskite solar cell module according to the third embodiment.
FIG. 38 is a schematic view illustrating a perovskite solar cell module according to a fourth embodiment.
FIGS. 39 to 49 are views illustrating other examples of the perovskite solar cell module according to the fourth embodiment.
FIG. 50 is a schematic view illustrating a perovskite solar cell module according to a fifth embodiment.
FIGS. 51 to 61 are views illustrating other examples of the perovskite solar cell module according to the fifth embodiment.
FIG. 62 is a schematic view illustrating a perovskite solar cell module according to a sixth embodiment.
FIGS. 63 to 73 are views illustrating other examples of the perovskite solar cell module according to the sixth embodiment.
FIG. 74 is a schematic view illustrating a perovskite solar cell module according to a seventh embodiment.
FIGS. 75 to 85 are views illustrating other examples of the perovskite solar cell module according to the seventh embodiment.
FIG. 86 is a schematic view illustrating a perovskite solar cell module according to an eighth embodiment.
FIGS. 87 to 97 are views illustrating other examples of the perovskite solar cell module according to the eighth embodiment.
FIG. 98 is a schematic view illustrating a perovskite solar cell module according to a ninth embodiment.
FIGS. 99 to 105 are views illustrating other examples of the perovskite solar cell module according to the ninth embodiment.
FIG. 106 is a schematic view illustrating a perovskite solar cell module according to a tenth embodiment.
FIGS. 107 to 113 are views illustrating other examples of the perovskite solar cell module according to the tenth embodiment.
FIG. 114 is a flowchart illustrating a manufacturing method for a perovskite solar cell module according to an embodiment.

### Best Mode

Hereinafter, a perovskite solar cell module and a manufacturing method for the same according to the present disclosure will be described in detail with reference to the accompanying drawings. The accompanying drawings are provided so that this disclosure will be complete and will fully convey the scope of the present disclosure to those skilled in the art. Accordingly, the present disclosure is not limited to the drawings and may be achieved in other ways, and it should be understood that the shape and size of the elements shown in the drawings may be exaggeratedly drawn to provide an easily understood description of the structure of the present disclosure. Unless otherwise defined, all terms including technical and scientific terms used herein have the same meaning as commonly understood by one of ordinary skill in the art to which the present disclosure belongs. Further, the detailed description of known functions and elements incorporated herein will be omitted to avoid unnecessarily obscuring the presented embodiments.

The perovskite solar cell module includes a substrate 110, a first electrode 120, a first charge transport layer 130, a photoactive layer 140, a second charge transport layer 150, a second electrode 160, and functional layers 150a and 150b. Each embodiment provides a perovskite solar cell module that is modified according to a structural change, and the position and shape of the functional layers 150a and 150b.

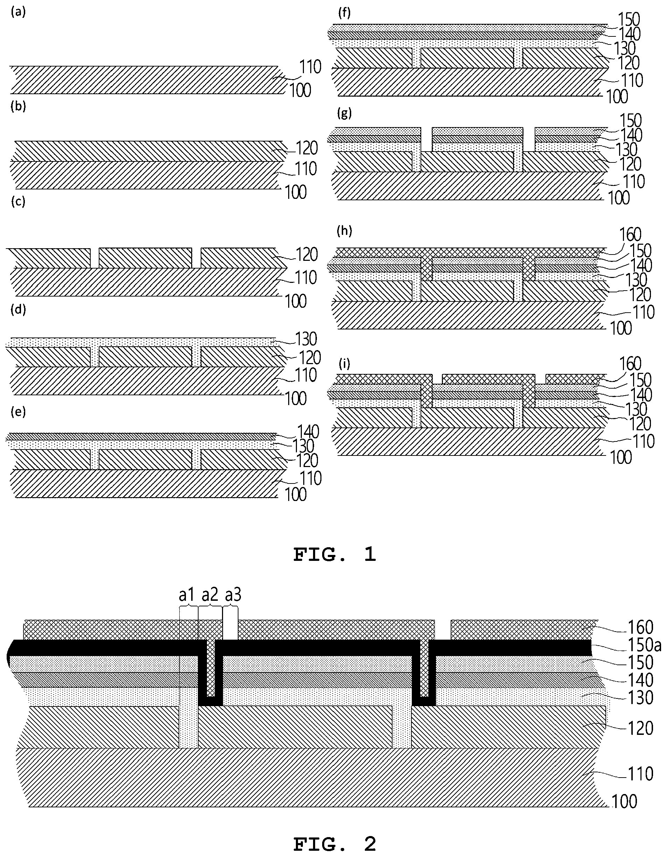

FIG. 1 is a schematic view illustrating a manufacturing sequence of a perovskite solar cell module according to an embodiment.

As illustrated in FIG. 1, the perovskite solar cell module is manufactured in the following manner. A first electrode 120 is formed on an upper surface of a substrate 110, and then the first electrode 120 is patterned through physical and chemical removal, such as dry etching, wet etching, laser, and mechanical processing, to be separated with first spaces a1 formed therein.

After patterning the first electrode 120, a first charge transport layer 130, a photoactive layer 140, and a second charge transport layer 150 are sequentially stacked on upper surfaces of the separated first electrodes 120. The first charge transport layer 130, the photoactive layer 140, and the second charge transport layer 150 stacked on the separated first electrodes 120 are patterned through physical and chemical removal, such as dry etching, wet etching, laser, and mechanical processing, to be separated with second spaces a2 formed therein.

After patterning the first charge transport layer 130, the photoactive layer 140, and the second charge transport layer 150, a second electrode 160 is stacked. Here, the second electrode 160 is stacked on upper surfaces of the separated second charge transport layers 150 and in the second spaces a2 formed on the separated first electrodes 120. After that, the second electrode 160 is patterned through physical and chemical removal, such as dry etching, wet etching, laser, and mechanical processing, to be separated with third spaces a3 formed therein.

Here, the width of the first spaces a1, the second spaces a2, and the third spaces a3 may be in the range of 0.01 um to 150 um.

Each separated second electrode 160 is formed to be in contact with an upper surface of an adjacent first electrode 120 and is electrically connected to the adjacent first electrode 120 to form the perovskite solar cell module.

Here, the substrate 110 may be made of a material selected from the group consisting of glass, polyethylene terephthalate (PET), polyethylene naphthalate (PEN), polyethersulfone (PES), polyimide (PI), crystalline silicon, and amorphous silicon, but is not limited thereto.

Each of the first electrode 120 and the second electrode 160 may be composed of at least one layer. The first electrode 120 and the second electrode 160 may be made of a material selected from the group consisting of indium tin oxide (ITO), fluorine-doped tin oxide (FTO), indium zinc oxide (IZO), aluminum zinc oxide (AZO), molybdenum trioxide (MoO₃), tungsten trioxide (WoO₃), indium gallium zinc oxide (IGZO), indium zinc-tin oxide (IZTO), metal NWs (silver nanowires, copper nanowires, etc.), carbon, graphene, reduced grapheme oxide (r-GO), PEDOT:PSS, aluminum (Al), silver (Ag), copper(Cu), and gold (Au), but are not limited thereto.

Each of the first charge transport layer 130 and the second charge transport layer 150 may be provided as at least one layer, and may be made of any one of materials having electron transport, hole transport, electron blocking, and hole blocking functions. Here, the materials having the function of electron transport, electron blocking, hole transport, and hole blocking are defined by a role according to the energy level of the materials, and the first charge transport layer 130 and the second charge transport layer 150 may be made of materials having opposite functions.

For example, in a case where each of the first charge transport layer 130 and the second charge transport layer 150 is provided as a single layer, when the first charge transport layer 130 is made of a material having an electron transport function, the second charge transport layer 150 may be made of a material having a hole transport function. However, the present disclosure is not limited thereto, and the first charge transport layer 130 may be made of a material having a hole transport function, and the second charge transport layer 150 may be made of a material having an electron transport function.

In addition, in a case where each of the first charge transport layer 130 and the second charge transport layer 150 is provided as at least one layer, when the first charge transport layer 130 is made of a material having an electron transport function, a material having a hole blocking function may be additionally provided, and when the second charge transport layer 150 is made of a material having a hole transport function, a material having an electron blocking function may be additionally provided.

The photoactive layer 140 is made of a material having a chemical composition of AMX₃. Here, A may be at least one metal element or organic compound, M may be any one of metal atoms, and X may be an oxide or a combination of any one or more of halogen atoms of chlorine (Cl), bromine (Br), and iodine (I). The A atom is located at each vertex of a cubic unit cell, the M atom is located at the body-center position, that is, the center of the body of the cell, and the X atom is located at the face-center position, that is, the center of each face of the cell. Representative examples include CH₃NHPbI₃ (methylammonium lead iodide, MAPbI₃) and HC(NH₂)₂PbI₃ (formamidinium lead iodide, FAPbI₃). In addition, when sunlight is absorbed into the photoactive layer 140, electrons maintained in a stable state in the photoactive layer 140 are excited. The excited electrons and holes formed due to the excited electrons move to adjacent charge transport layers. That is, the electrons move to a charge transport layer having the function of electron transport, and the holes move to a charge transport layer having the function of hole transport. Here, each of the charge transport layers is defined by a role according to the energy level of the material thereof.

A perovskite solar cell module according to each embodiment described below may further include functional layers 150a and 150b in addition to the substrate 110, the first electrode 120, the first charge transport layer 130, the photoactive layer 140, the second charge transport layer 150, and the second electrode 160.

Here, the functional layers 150a and 150b may be made of a non-metal-based material formed by combining at least one or more of hydrogen (H), carbon (C), nitrogen (N), oxygen (O), fluorine (F), neon (Ne), phosphorus (P), sulfur (S), chlorine (Cl), argon (Ar), selenium (Se), bromine (Br), krypton (Kr), iodine (I), xenon (Xe), radon (Rn), and astatine (At ), but are not limited thereto.

Modified examples of the perovskite solar cell module according to the embodiment will be described in first to sixth embodiments. Each of the first to fourth embodiments will be described with reference to one schematic view and 23 exemplary views, and each of the fifth and sixth embodiments will be described with reference to one schematic view and seven exemplary views. The structure of modified examples of each embodiment may vary depending on a structural change of the above-described perovskite solar cell module including the first electrode 120, the first charge transport layer 130, the photoactive layer 140, the second charge transport layer 150, and the second electrode 160, and the position and shape of the functional layers 150a and 150b.

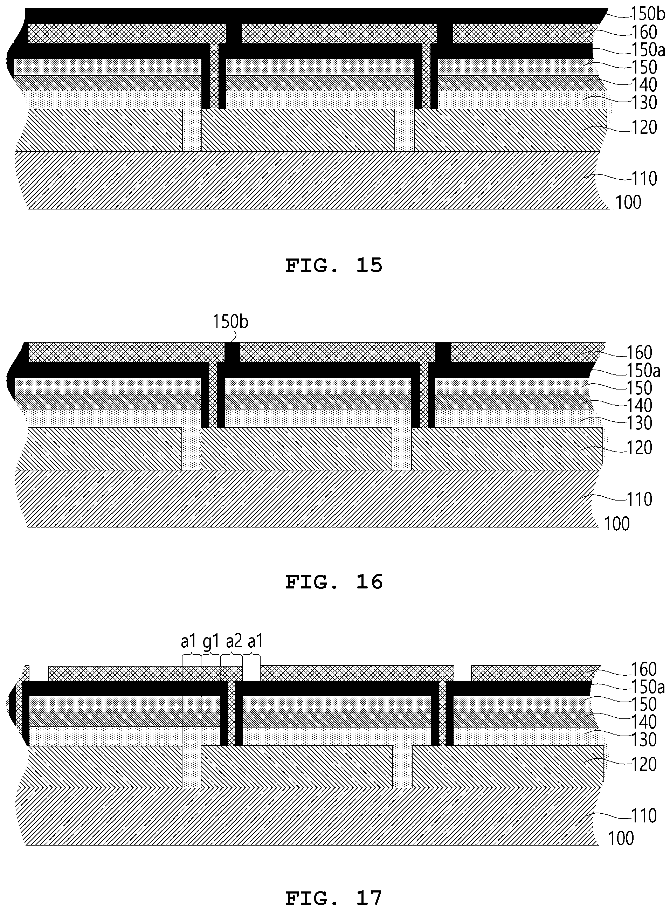

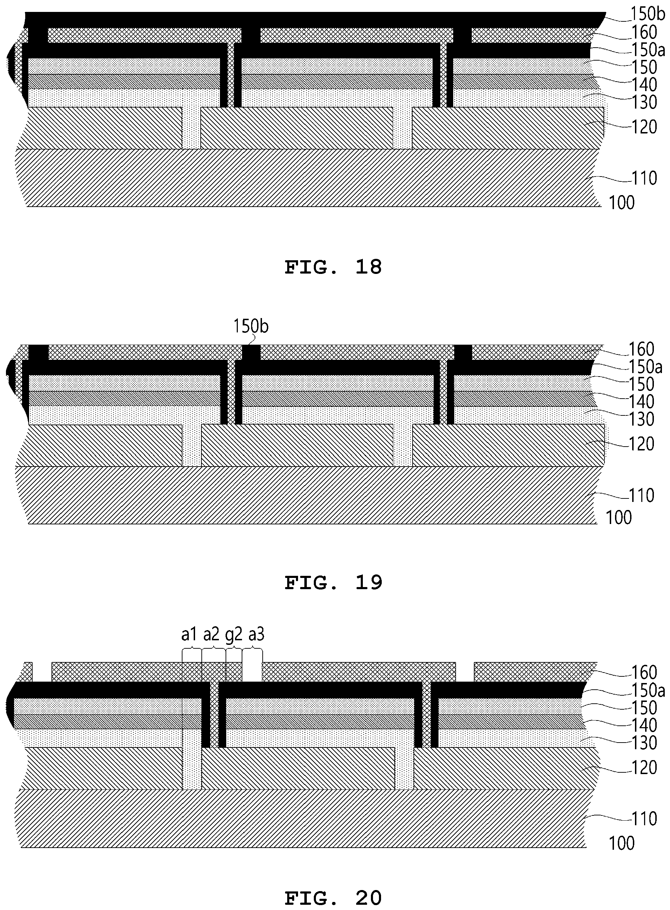

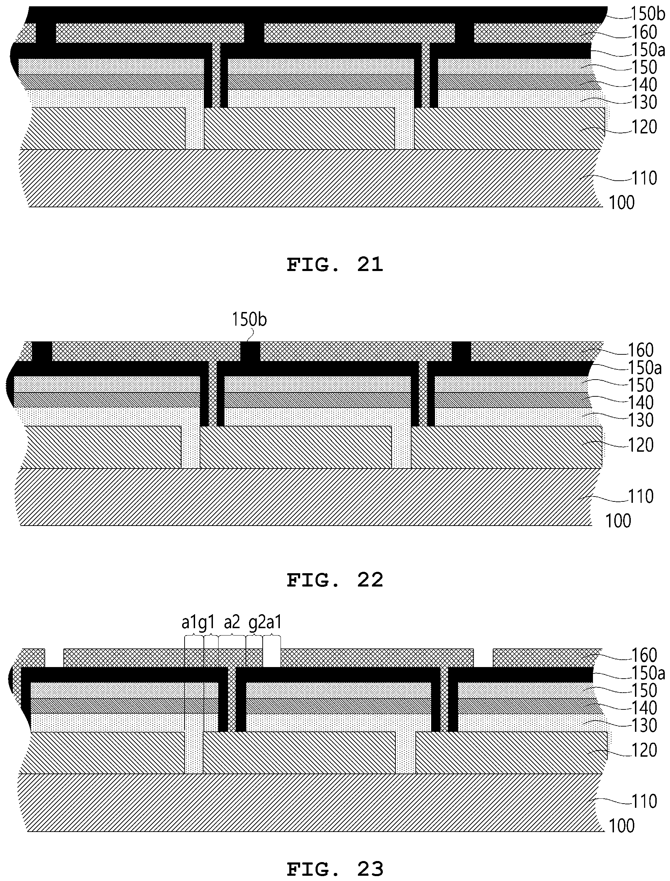

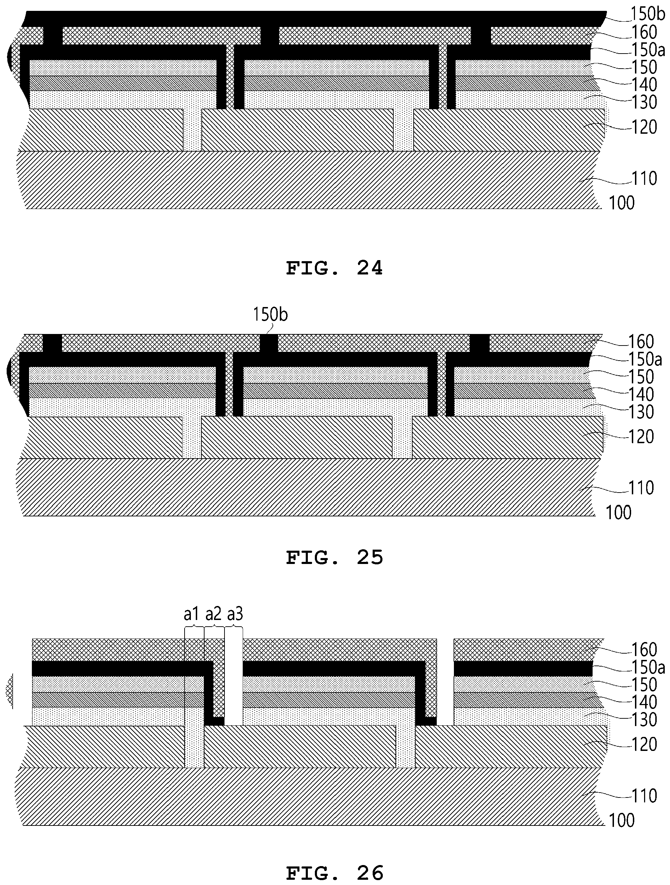

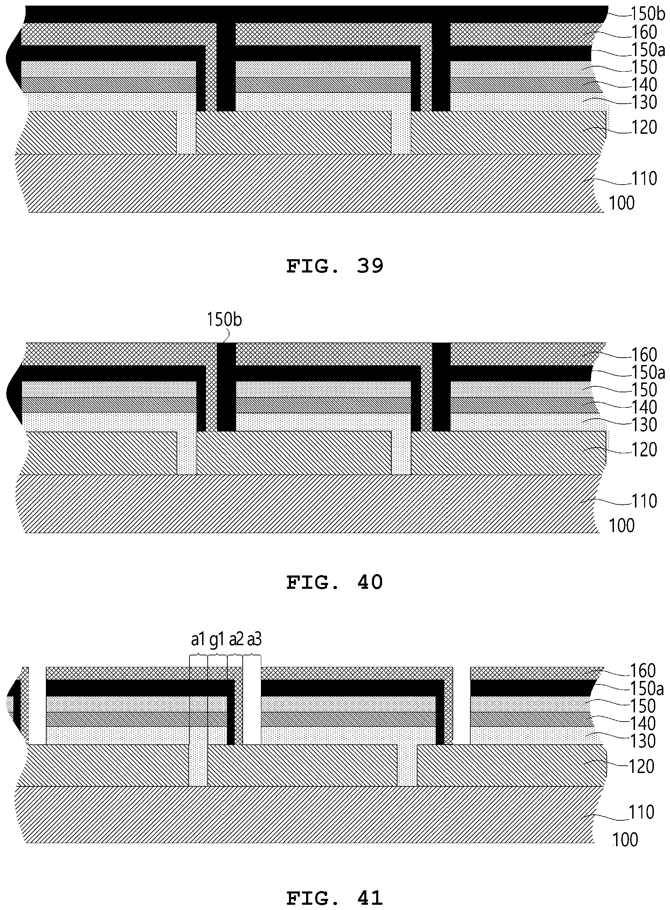

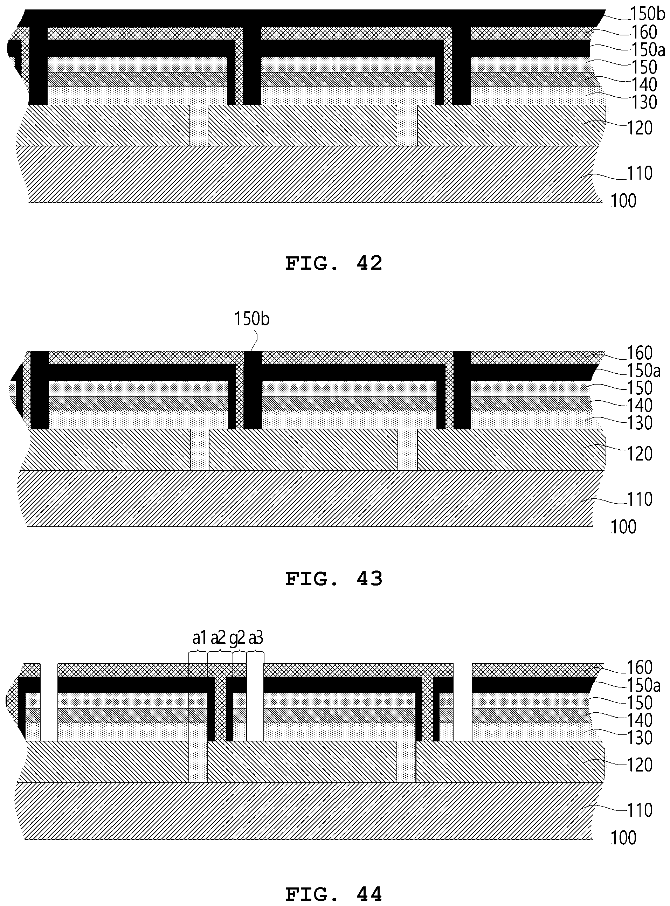

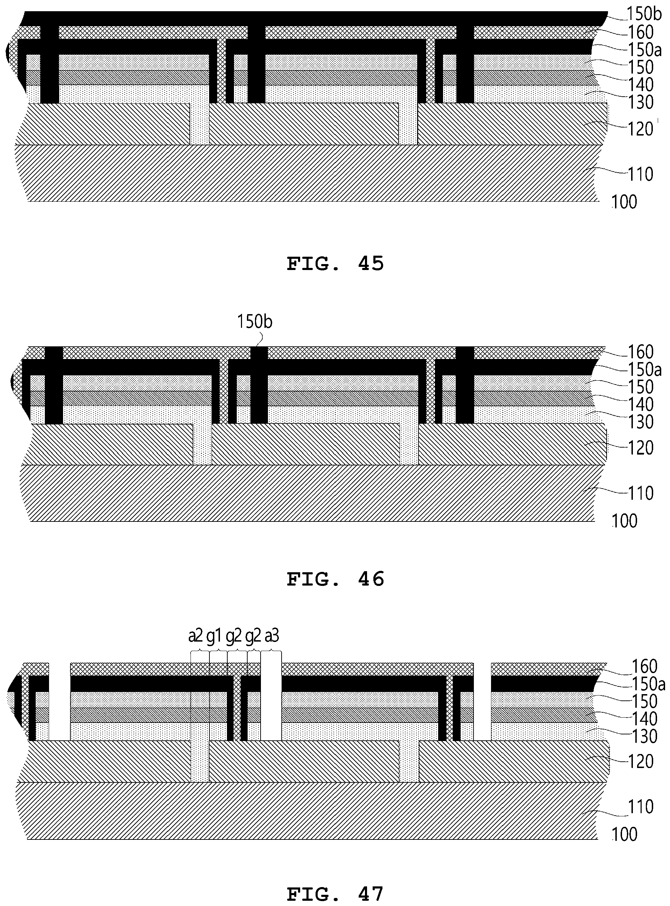

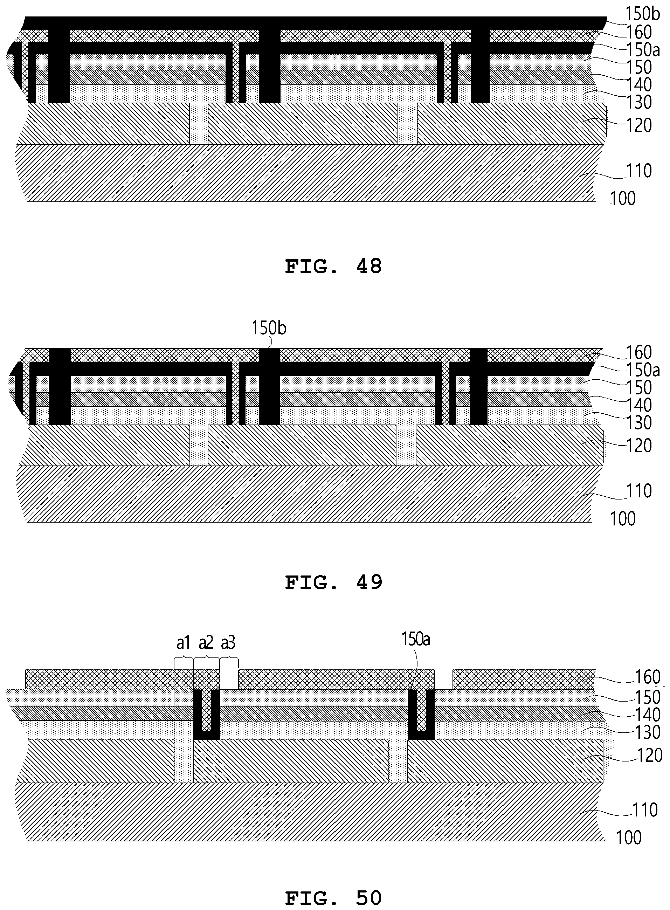

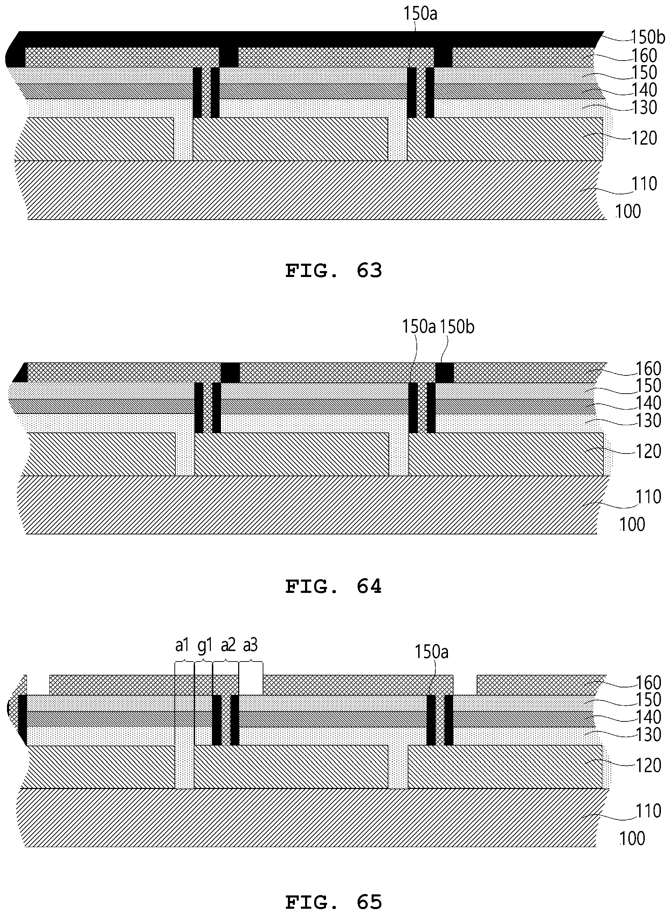

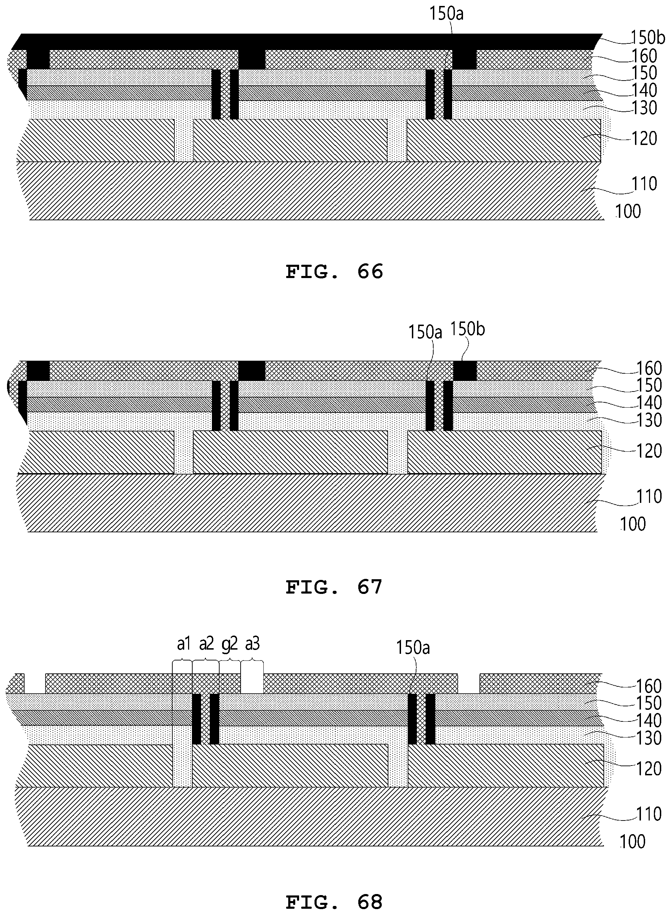

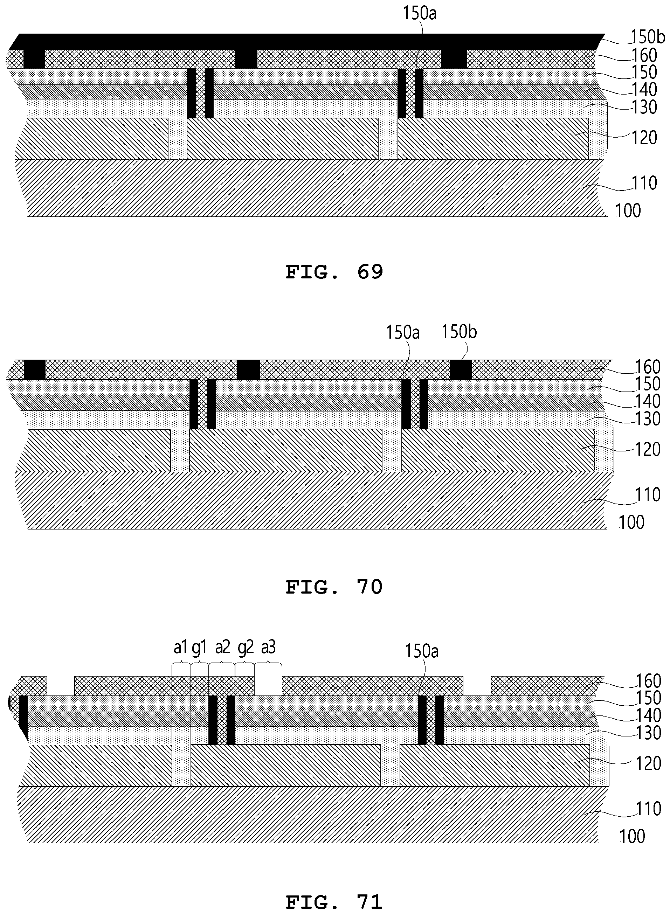

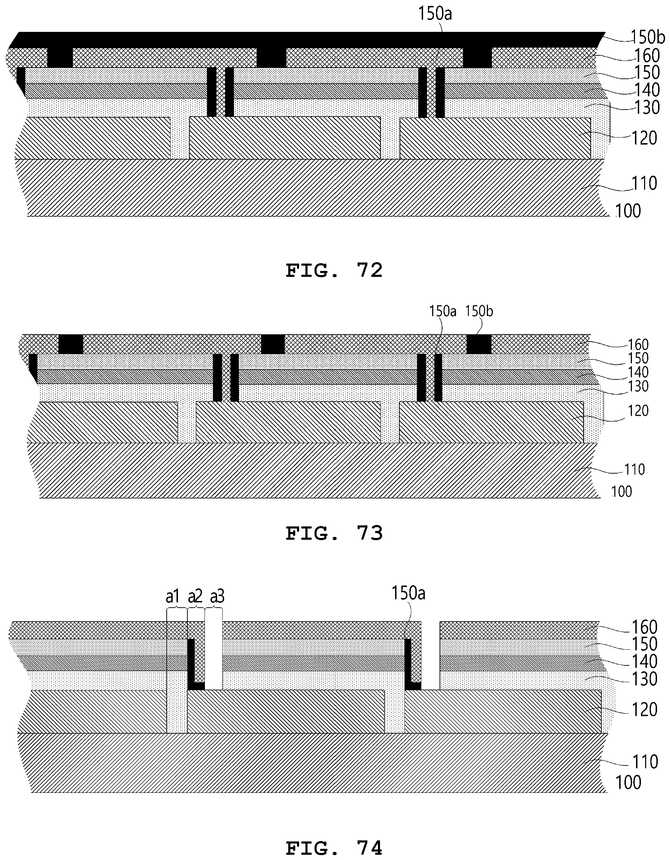

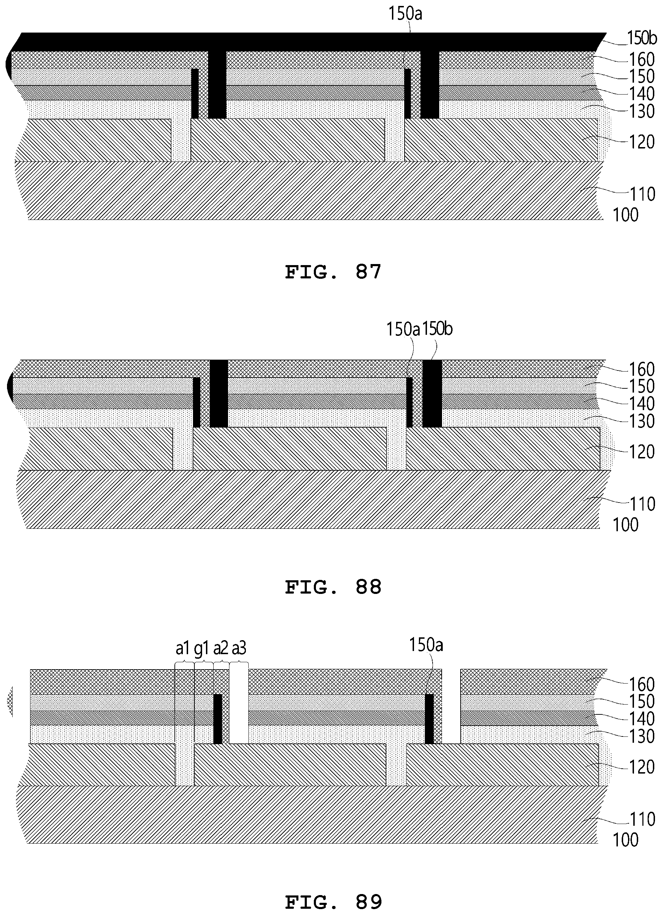

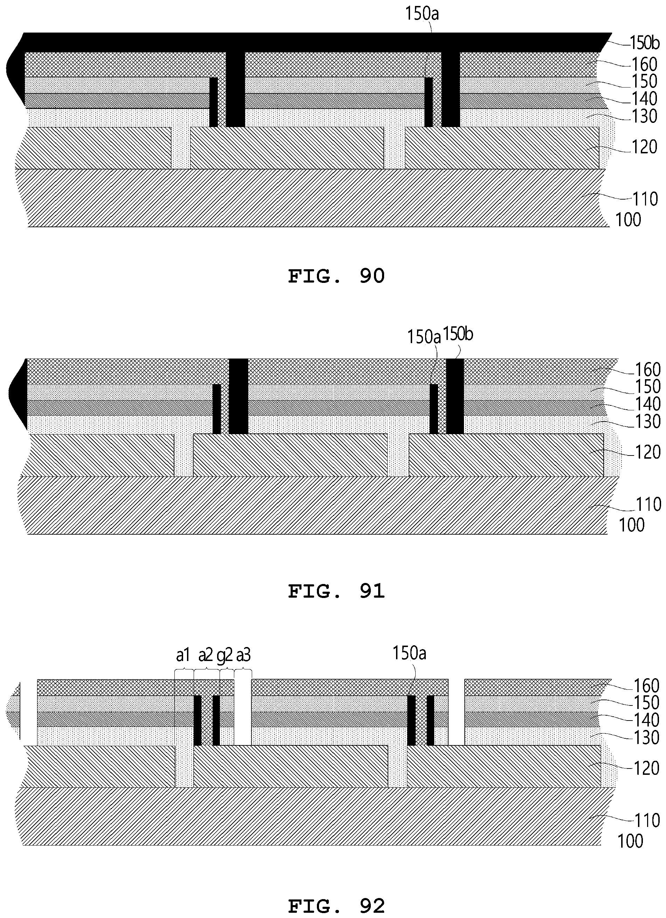

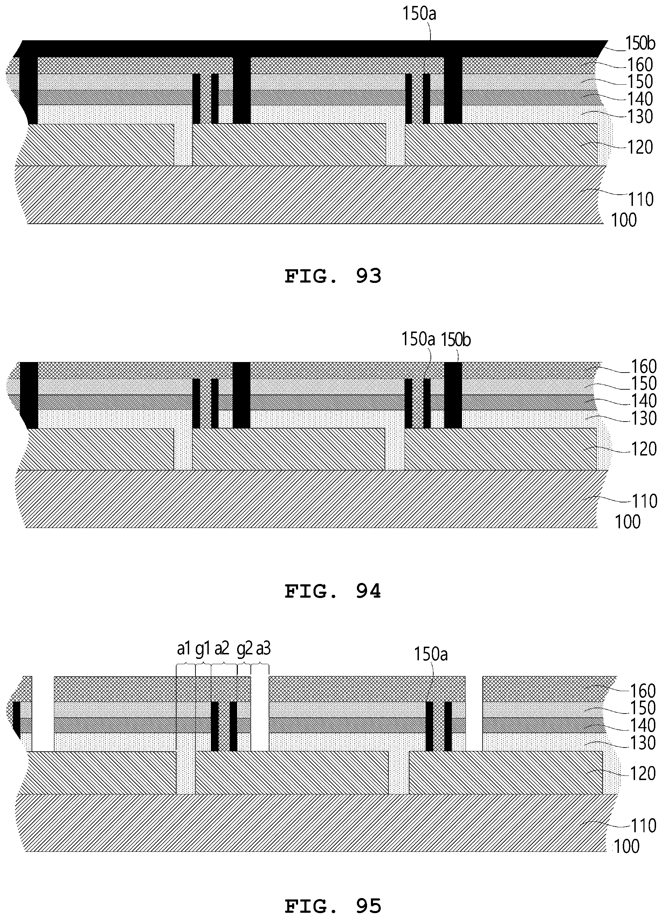

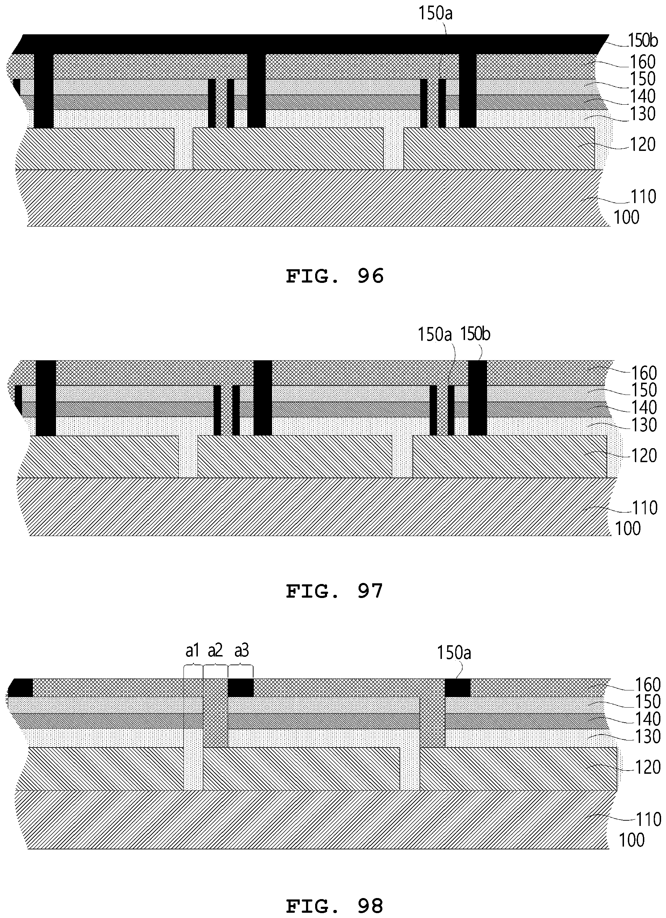

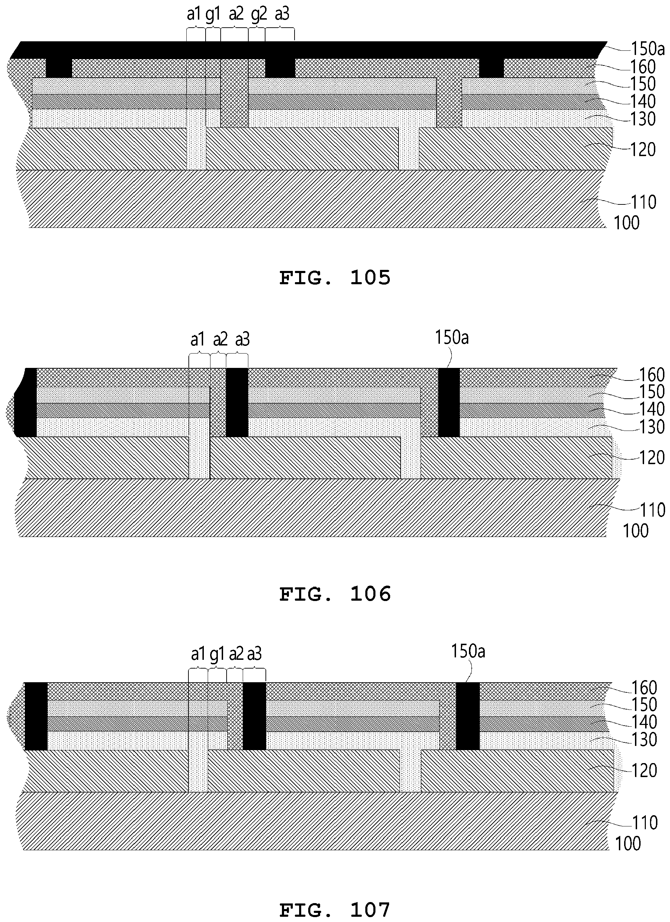

Each embodiment and modified examples thereof will be described with reference to FIGS. 2 to 113. A perovskite solar cell module according to the first embodiment will be described with reference to FIGS. 2 to 25. A perovskite solar cell module according to the second embodiment will be described with reference to FIGS. 26 to 49. A perovskite solar cell module according to the third embodiment will be described with reference to FIGS. 50 to 73. A perovskite solar cell module according to the fourth embodiment will be described with reference to FIGS. 74 to 97. A perovskite solar cell module according to the fifth embodiment will be described with reference to FIGS. 98 to 105. A perovskite solar cell module according to the sixth embodiment will be described with reference to FIGS. 106 to 113.

### First embodiment

FIG. 2 is a schematic view illustrating the perovskite solar cell module according to the first embodiment.

As illustrated in FIG. 2, the perovskite solar cell module 100 according to the first embodiment includes a substrate 110, a first electrode 120, a first charge transport layer 130, a photoactive layer 140, a second charge transport layer 150, a functional layer 150a, and a second electrode 160.

The first electrode 120 is stacked on an upper surface of the substrate 110, and patterned through physical and chemical removal, such as dry etching, wet etching, laser, and mechanical processing, to be separated with first spaces a1 formed therein.

The first charge transport layer 130, the photoactive layer 140, and the second charge transport layer 150 are sequentially stacked on upper surfaces of the separated first electrodes 120.

The first charge transport layer 130, the photoactive layer 140, and the second charge transport layer 150 stacked on the separated first electrodes 120 are patterned through physical and chemical removal, such as dry etching, wet etching, laser, and mechanical processing, to be separated with second spaces a2 formed therein.

The functional layer 150a is stacked on upper surfaces of the separated second charge transport layers 150 and in the second spaces a2 formed between the separated first charge transport layers 130, the separated photoactive layers 140, and the separated second charge transport layers 150.

The second electrode 160 is stacked on an upper surface of the functional layer 150a. Here, the second electrode 160 is patterned through physical and chemical removal, such as dry etching, wet etching, laser, and mechanical processing, to be separated with third spaces a3 formed therein.

Since perovskite solar cell modules described in detail below that are modified from the first embodiment are configured in a manner similar to that described in FIG. 2, a detailed description thereof will be omitted. However, when structural changes, modifications, and variations are made therein, a description thereof will be given.

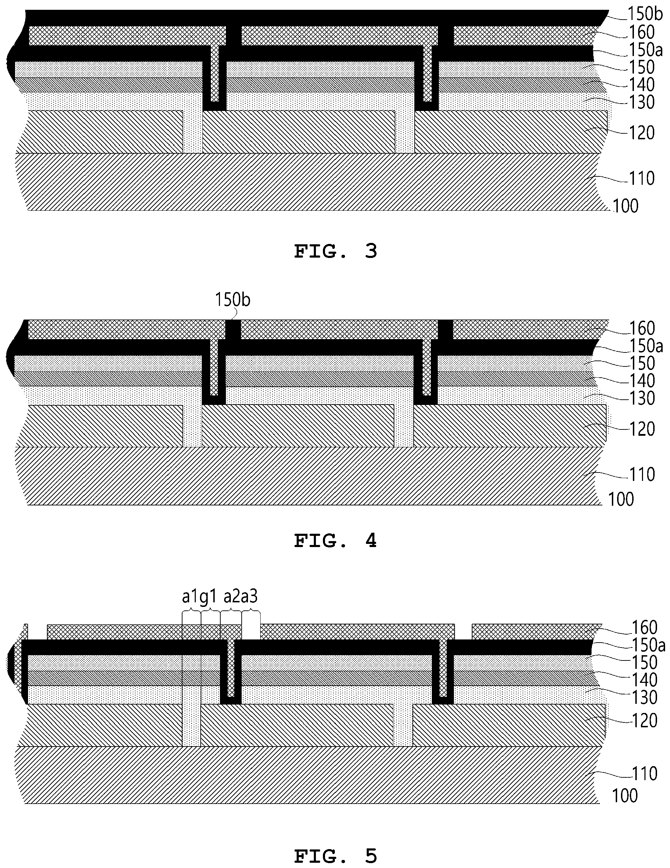

FIGS. 3 to 13 are views illustrating other examples of the perovskite solar cell module according to the first embodiment illustrated in FIG. 2.

FIG. 3 is a view illustrating a first example of the perovskite solar cell module according to the first embodiment.

As illustrated in FIG. 3, the first example of the perovskite solar cell module according to the first embodiment including a substrate 110, a first electrode 120, a first charge transport layer 130, a photoactive layer 140, a second charge transport layer 150, a functional layer 150a, and a second electrode 160 further includes a functional layer 150b. The functional layer 150b is formed on a surface of each of separated second electrodes 160, and is stacked on upper surfaces of the separated second electrodes 160 and in third spaces a3 formed between the separated second electrodes 160.

FIG. 4 is a view illustrating a second example of the perovskite solar cell module according to the first embodiment.

As illustrated in FIG. 4, the second example of the perovskite solar cell module according to the first embodiment including a substrate 110, a first electrode 120, a first charge transport layer 130, a photoactive layer 140, a second charge transport layer 150, a functional layer 150a, and a second electrode 160 further includes a functional layer 150b. The functional layer 150b is formed on a surface of each of separated second electrodes 160, and is stacked in third spaces a3 formed between the separated second electrodes 160.

FIG. 5 is a view illustrating a third example of the perovskite solar cell module according to the first embodiment.

As illustrated in FIG. 5, the third example of the perovskite solar cell module according to the first embodiment includes a substrate 110, a first electrode 120, a first charge transport layer 130, a photoactive layer 140, a second charge transport layer 150, a functional layer 150a, and a second electrode 160.

The first charge transport layer 130, the photoactive layer 140, and the second charge transport layer 150 are stacked on separated first electrodes 120 and patterned through physical and chemical removal, such as dry etching, wet etching, laser, and mechanical processing, to be separated with second spaces a2 formed therein. Here, the first charge transport layer 130, the photoactive layer 140, and the second charge transport layer 150 are patterned so that a first gap g1 exists between a first space a1 and a second space a2.

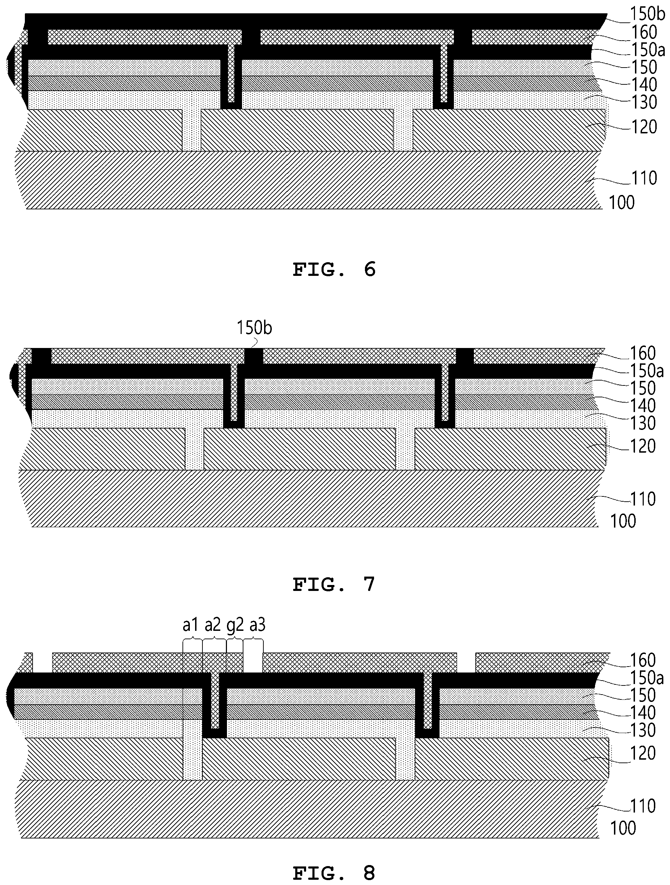

Perovskite solar cell modules modified from the third example of the perovskite solar cell module according to the first embodiment described above with reference to FIG. 5 will be described with reference to FIGS. 6 and 7.

FIG. 6 is a view illustrating a fourth example of the perovskite solar cell module according to the first embodiment.

As illustrated in FIG. 6, the fourth example of the perovskite solar cell module according to the first embodiment including a substrate 110, a first electrode 120, a first charge transport layer 130, a photoactive layer 140, a second charge transport layer 150, a functional layer 150a, and a second electrode 160 further includes a functional layer 150b. The functional layer 150b is formed on a surface of each of separated second electrodes 160, and is stacked on upper surfaces of the separated second electrodes 160 and in third spaces a3 formed between the separated second electrodes 160.

FIG. 7 is a view illustrating a fifth example of the perovskite solar cell module according to the first embodiment.

As illustrated in FIG. 7, the fifth example of the perovskite solar cell module according to the first embodiment including a substrate 110, a first electrode 120, a first charge transport layer 130, a photoactive layer 140, a second charge transport layer 150, a functional layer 150a, and a second electrode 160 further includes a functional layer 150b. The functional layer 150b is formed on a surface of each of separated second electrodes 160, and is stacked in third spaces a3 formed between the separated second electrodes 160.

FIG. 8 is a view illustrating a sixth example of the perovskite solar cell module according to the first embodiment.

As illustrated in FIG. 8, the sixth example of the perovskite solar cell module according to the first embodiment includes a substrate 110, a first electrode 120, a first charge transport layer 130, a photoactive layer 140, a second charge transport layer 150, a functional layer 150a, and a second electrode 160.

The second electrode 160 is stacked on an upper surface of the functional layer 150a and patterned to be separated with third spaces a3 formed therein. Here, the second electrode 160 is patterned so that a second gap g2 exists between a second space a2 and a third space a3.

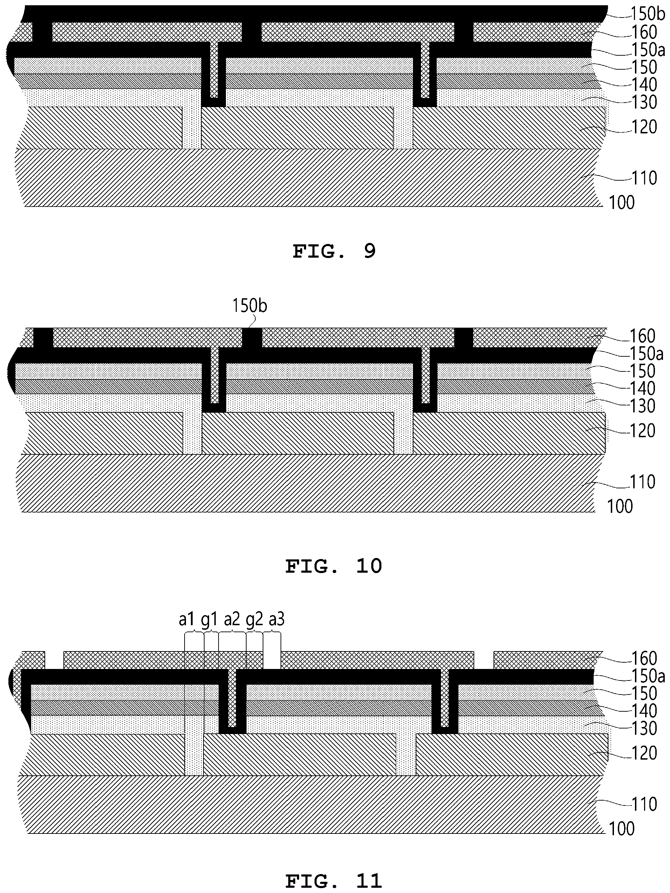

Perovskite solar cell modules modified from the sixth example of the perovskite solar cell module according to the first embodiment described above with reference to FIG. 8 will be described with reference to FIGS. 9 and 10.

FIG. 9 is a view illustrating a seventh example of the perovskite solar cell module according to the first embodiment.

As illustrated in FIG. 9, the seventh example of the perovskite solar cell module according to the first embodiment including a substrate 110, a first electrode 120, a first charge transport layer 130, a photoactive layer 140, a second charge transport layer 150, a functional layer 150a, and a second electrode 160 further includes a functional layer 150b. The functional layer 150b is formed on a surface of each of separated second electrodes 160, and is stacked on upper surfaces of the separated second electrodes 160 and in third spaces a3 formed between the separated second electrodes 160.

FIG. 10 is a view illustrating an eighth example of the perovskite solar cell module according to the first embodiment.

As illustrated in FIG. 10, the eighth example of the perovskite solar cell module according to the first embodiment including a substrate 110, a first electrode 120, a first charge transport layer 130, a photoactive layer 140, a second charge transport layer 150, a functional layer 150a, and a second electrode 160 further includes a functional layer 150b. The functional layer 150b is formed on a surface of each of separated second electrodes 160, and is stacked in third spaces a3 formed between the separated second electrodes 160.

FIG. 11 is a view illustrating a ninth example of the perovskite solar cell module according to the first embodiment.

As illustrated in FIG. 11, the ninth example of the perovskite solar cell module according to the first embodiment includes a substrate 110, a first electrode 120, a first charge transport layer 130, a photoactive layer 140, a second charge transport layer 150, a functional layer 150a, and a second electrode 160.

The first charge transport layer 130, the photoactive layer 140, and the second charge transport layer 150 are stacked on separated first electrodes 120 and patterned through physical and chemical removal, such as dry etching, wet etching, laser, and mechanical processing, to be separated with second spaces a2 formed therein. Here, the first charge transport layer 130, the photoactive layer 140, and the second charge transport layer 150 are patterned so that a first gap g1 exists between a first space a1 and a second space a2. In addition, the second electrode 160 is stacked on an upper surface of the functional layer 150a and patterned through physical and chemical removal, such as dry etching, wet etching, laser, and mechanical processing, to be separated with third spaces a3 formed therein. Here, the second electrode 160 is patterned so that a second gap g2 exists between a second space a2 and a third space a3.

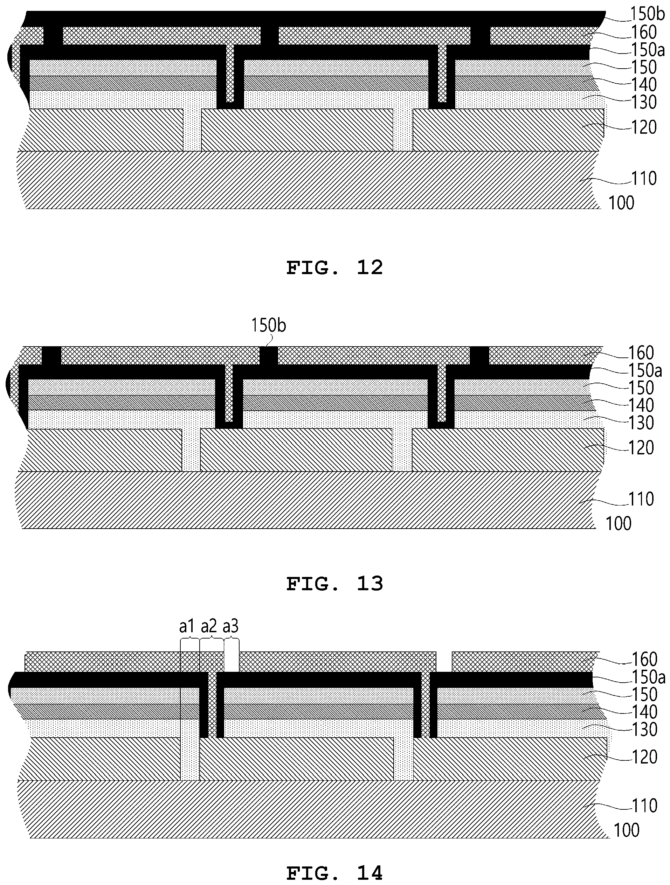

Perovskite solar cell modules modified from the ninth example of the perovskite solar cell module according to the first embodiment described above with reference to FIG. 11 will be described with reference to FIGS. 12 and 13.

FIG. 12 is a view illustrating a tenth example of the perovskite solar cell module according to the first embodiment.

As illustrated in FIG. 12, the tenth example of the perovskite solar cell module according to the first embodiment including a substrate 110, a first electrode 120, a first charge transport layer 130, a photoactive layer 140, a second charge transport layer 150, a functional layer 150a, and a second electrode 160 further includes a functional layer 150b. The functional layer 150b is stacked on upper surfaces of separated second electrodes 160 and in third spaces a3 formed between the separated second electrodes 160.

FIG. 13 is a view illustrating an eleventh example of the perovskite solar cell module according to the first embodiment.

As illustrated in FIG. 13, the eleventh example of the perovskite solar cell module according to the first embodiment including a substrate 110, a first electrode 120, a first charge transport layer 130, a photoactive layer 140, a second charge transport layer 150, a functional layer 150a, and a second electrode 160 further includes a functional layer 150b. The functional layer 150b is stacked in third spaces a3 formed between separated second electrodes 160.

FIGS. 14 to 25 are views illustrating modified structures of the first to eleventh examples of the perovskite solar cell module according to the first embodiment described above. A functional layer 150a is patterned through physical and chemical removal, such as dry etching, wet etching, laser, and mechanical processing, so that each second electrode 160 is in contact with and electrically connected to an adjacent first electrode 120.

### Second embodiment

FIG. 26 is a schematic view illustrating a perovskite solar cell module according to a second embodiment.

As illustrated in FIG. 26, the perovskite solar cell module 100 according to the first embodiment includes a substrate 110, a first electrode 120, a first charge transport layer 130, a photoactive layer 140, a second charge transport layer 150, a functional layer 150a, and a second electrode 160.

The first electrode 120 is stacked on an upper surface of the substrate 110, and patterned through physical and chemical removal, such as dry etching, wet etching, laser, and mechanical processing, to be separated with first spaces a1 formed therein.

The first charge transport layer 130, the photoactive layer 140, and the second charge transport layer 150 are sequentially stacked on upper surfaces of the separated first electrodes 120.

The first charge transport layer 130, the photoactive layer 140, and the second charge transport layer 150 stacked on the separated first electrodes 120 are patterned through physical and chemical removal, such as dry etching, wet etching, laser, and mechanical processing, to be separated with second spaces a2 formed therein.

The functional layer 150a is stacked on upper surfaces of the separated second charge transport layers 150 and in the second spaces a2.

The second electrode 160 is stacked on an upper surface of the functional layer 150a. The separated first charge transport layers 130, the separated photoactive layers 140, the separated second charge transport layers 150, the functional layer 150a, and the second electrode 160 stacked on the separated first electrodes 120 are patterned through physical and chemical removal, such as dry etching, wet etching, laser, and mechanical processing, to be separated with third spaces a3 formed therein.

Since perovskite solar cell modules described in detail below that are modified from the second embodiment are configured in a manner similar to that described in FIG. 26, a detailed description thereof will be omitted. However, when structural changes, modifications, and variations are made therein, a description thereof will be given.

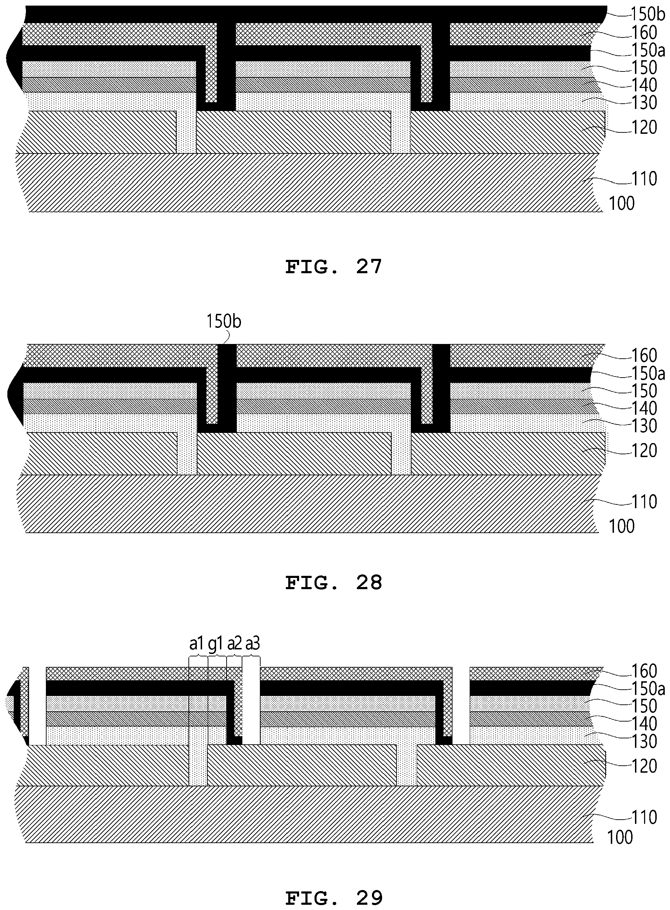

FIGS. 27 to 49 are views illustrating other examples of the perovskite solar cell module according to the second embodiment illustrated in FIG. 26.

FIG. 27 is a view illustrating a first example of the perovskite solar cell module according to the second embodiment.

As illustrated in FIG. 27, the first example of the perovskite solar cell module according to the second embodiment including a substrate 110, a first electrode 120, a first charge transport layer 130, a photoactive layer 140, a second charge transport layer 150, a functional layer 150a, and a second electrode 160 further includes a functional layer 150b. The functional layer 150b is formed on a surface of each of separated second electrodes 160, and is stacked on upper surfaces of the separated second electrodes 160 and in third spaces a3 formed between separated first charge transport layers 130, separated photoactive layers 140, separated second charge transport layers 150, separated functional layers 150a, and the separated second electrodes 160.

FIG. 28 is a view illustrating a second example of the perovskite solar cell module according to the second embodiment.

As illustrated in FIG. 28, the second example of the perovskite solar cell module according to the second embodiment including a substrate 110, a first electrode 120, a first charge transport layer 130, a photoactive layer 140, a second charge transport layer 150, a functional layer 150a, and a second electrodes 160 further includes a functional layer 150b. The functional layer 150b is formed on a surface of each of separated second electrodes 160, and is stacked in third spaces a3 formed between separated first charge transport layers 130, separated photoactive layers 140, separated second charge transport layers 150, separated functional layers 150a, and the separated second electrodes 160.

FIG. 29 is a view illustrating a third example of the perovskite solar cell module according to the second embodiment.

As illustrated in FIG. 29, the third example of the perovskite solar cell module according to the second embodiment includes a substrate 110, a first electrode 120, a first charge transport layer 130, a photoactive layer 140, a second charge transport layer 150, a functional layer 150a, and a second electrode 160.

The first charge transport layer 130, the photoactive layer 140, and the second charge transport layer 150 are stacked on separated first electrodes 120 and patterned through physical and chemical removal, such as dry etching, wet etching, laser, and mechanical processing, to be separated with second spaces a2 formed therein. Here, the first charge transport layer 130, the photoactive layer 140, and the second charge transport layer 150 are patterned so that a first gap g1 exists between a first space a1 and a second space a2.

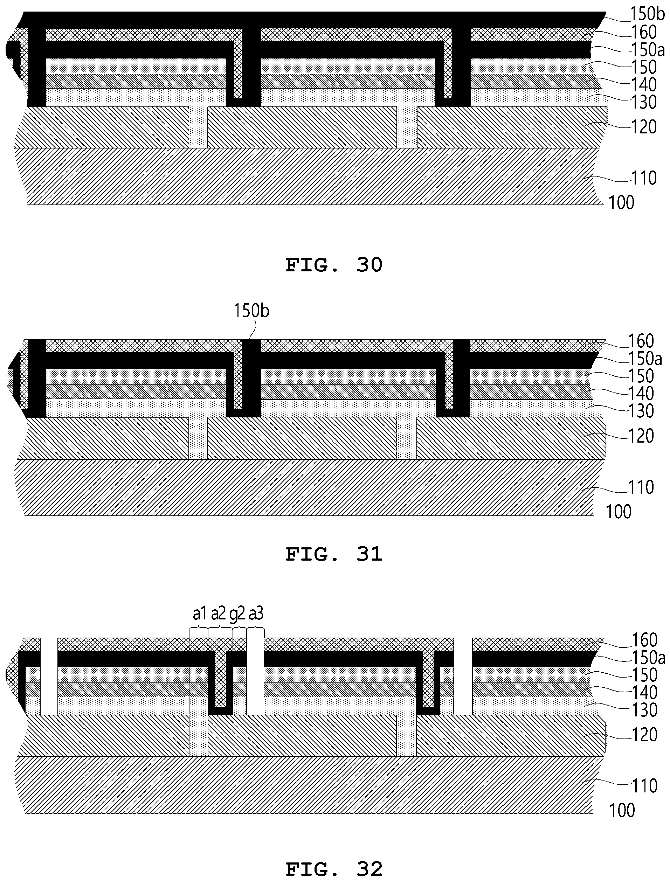

Perovskite solar cell modules modified from the third example of the perovskite solar cell module according to the second embodiment described above with reference to FIG. 29 will be described with reference to FIGS. 30 and 31.

FIG. 30 is a view illustrating a fourth example of the perovskite solar cell module according to the second embodiment.

As illustrated in FIG. 30, the fourth example of the perovskite solar cell module according to the second embodiment including a substrate 110, a first electrode 120, a first charge transport layer 130, a photoactive layer 140, a second charge transport layer 150, a functional layer 150a, and a second electrode 160 further includes a functional layer 150b. The functional layer 150b is formed on a surface of each of separated second electrodes 160, and is stacked on upper surfaces of the separated second electrodes 160 and in third spaces a3 formed between separated first charge transport layers 130, separated photoactive layers 140, separated second charge transport layers 150, separated functional layers 150a, and the separated second electrodes 160.

FIG. 31 is a view illustrating a fifth example of the perovskite solar cell module according to the second embodiment.

As illustrated in FIG. 31, the fifth example of the perovskite solar cell module according to the second embodiment including a substrate 110, a first electrode 120, a first charge transport layer 130, a photoactive layer 140, a second charge transport layer 150, a functional layer 150a, and a second electrode 160 further includes a functional layer 150b. The functional layer 150b is stacked in third spaces a3 formed between separated first charge transport layers 130, separated photoactive layers 140, separated second charge transport layers 150, separated functional layers 150a, and separated second electrodes 160.

FIG. 32 is a view illustrating a sixth example of the perovskite solar cell module according to the second embodiment.

As illustrated in FIG. 32, the sixth example of the perovskite solar cell module according to the second embodiment includes a substrate 110, a first electrode 120, a first charge transport layer 130, a photoactive layer 140, a second charge transport layer 150, a functional layer 150a, and a second electrode 160.

Separated first charge transport layers 130, separated photoactive layers 140, separated second charge transport layers 150, the functional layer 150a, and the second electrode 160 stacked on separated first electrodes 120 are patterned through physical and chemical removal, such as dry etching, wet etching, laser, and mechanical processing, to be separated with second spaces a2 formed therein. Here, the separated first charge transport layers 130, the separated photoactive layers 140, the separated second charge transport layers 150, the functional layer 150a, and the second electrode 160 are patterned so that a second gap g2 exists between a second space a2 and a third space a3.

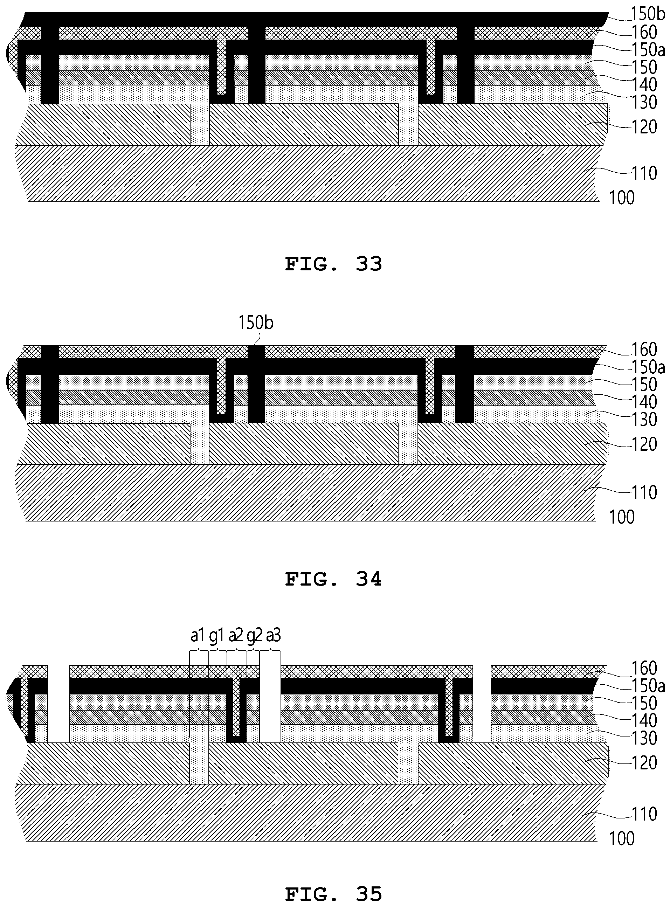

Perovskite solar cell modules modified from the sixth example of the perovskite solar cell module according to the second embodiment described above with reference to FIG. 32 will be described with reference to FIGS. 33 and 34.

FIG. 33 is a view illustrating a seventh example of the perovskite solar cell module according to the second embodiment.

As illustrated in FIG. 33, the seventh example of the perovskite solar cell module according to the second embodiment including a substrate 110, a first electrode 120, a first charge transport layer 130, a photoactive layer 140, a second charge transport layer 150, a functional layer 150a, and a second electrode 160 further includes a functional layer 150b. The functional layer 150b is formed on a surface of each of separated second electrodes 160, and is stacked on upper surfaces of the separated second electrodes 160 and in third spaces a3 formed between separated first charge transport layers 130, separated photoactive layers 140, separated second charge transport layers 150, separated functional layers 150a, and the separated second electrodes 160.

FIG. 34 is a view illustrating an eighth example of the perovskite solar cell module according to the second embodiment.

As illustrated in FIG. 34, the eighth example of the perovskite solar cell module according to the second embodiment including a substrate 110, a first electrode 120, a first charge transport layer 130, a photoactive layer 140, a second charge transport layer 150, a functional layer 150a, and a second electrode 160 further includes a functional layer 150b. The functional layer 150b is stacked in third spaces a3 formed between separated first charge transport layers 130, separated photoactive layers 140, separated second charge transport layers 150, separated functional layers 150a, and separated second electrodes 160.

FIG. 35 is a view illustrating a ninth example of the perovskite solar cell module according to the second embodiment.

As illustrated in FIG. 35, the ninth example of the perovskite solar cell module according to the second embodiment includes a substrate 110, a first electrode 120, a first charge transport layer 130, a photoactive layer 140, a second charge transport layer 150, a functional layer 150a, and a second electrode 160.

The first charge transport layer 130, the photoactive layer 140, and the second charge transport layer 150 are stacked on separated first electrodes 120 and patterned through physical and chemical removal, such as dry etching, wet etching, laser, and mechanical processing, to be separated with second spaces a2 formed therein. Here, the first charge transport layer 130, the photoactive layer 140, and the second charge transport layer 150 are patterned so that a first gap g1 exists between a first space a1 and a second space a2. In addition, the separated first charge transport layers 130, the separated photoactive layers 140, the separated second charge transport layers 150, the functional layer 150a, and the second electrode 160 stacked on the separated first electrode 120 are patterned through physical and chemical removal, such as dry etching, wet etching, laser, and mechanical processing, to be separated with third spaces a3 formed therein. Here, the separated first charge transport layers 130, the separated photoactive layers 140, the separated second charge transport layers 150, the functional layer 150a, and the second electrode 160 are patterned so that a second gap g2 exists between a second space a2 and a third space a3.

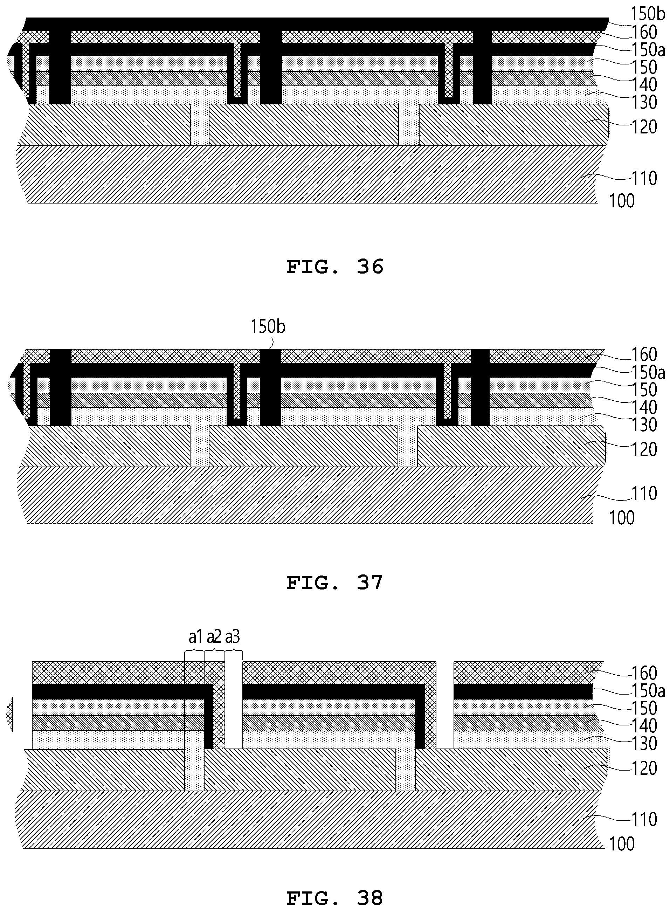

Perovskite solar cell modules modified from the ninth example of the perovskite solar cell module according to the second embodiment described above with reference to FIG. 35 will be described with reference to FIGS. 36 and 37.

FIG. 36 is a view illustrating a tenth example of the perovskite solar cell module according to the second embodiment.

As illustrated in FIG. 36, the tenth example of the perovskite solar cell module according to the second embodiment including a substrate 110, a first electrode 120, a first charge transport layer 130, a photoactive layer 140, a second charge transport layer 150, a functional layer 150a, and a second electrode 160 further includes a functional layer 150b. The functional layer 150b is formed on a surface of each of separated second electrodes 160, and is stacked on upper surfaces of the separated second electrodes 160 and in third spaces a3 formed between separated first charge transport layers 130, separated photoactive layers 140, separated second charge transport layers 150, separated functional layers 150a, and the separated second electrodes 160.

FIG. 37 is a view illustrating an eleventh example of the perovskite solar cell module according to the second embodiment.

As illustrated in FIG. 37, the eleventh example of the perovskite solar cell module according to the second embodiment including a substrate 110, a first electrode 120, a first charge transport layer 130, a photoactive layer 140, a second charge transport layer 150, a functional layer 150a, and a second electrode 160 further includes a functional layer 150b. The functional layer 150b is formed on a surface of each of separated second electrodes 160, and is stacked in third spaces a3 formed between separated first charge transport layers 130, separated photoactive layers 140, separated second charge transport layers 150, separated functional layers 150a, and the separated second electrodes 160.

FIGS. 38 to 39 are views illustrating modified structures of the first to eleventh examples of the perovskite solar cell module according to the second embodiment described above. A functional layer 150a is patterned through physical and chemical removal, such as dry etching, wet etching, laser, and mechanical processing, so that each second electrode 160 is in contact with and electrically connected to an adjacent first electrode 120.

### Third embodiment

FIG. 50 is a schematic view illustrating a perovskite solar cell module according to a third embodiment.

As illustrated in FIG. 50, the perovskite solar cell module 100 according to the third embodiment includes a substrate 110, a first electrode 120, a first charge transport layer 130, a photoactive layer 140, a second charge transport layer 150, a functional layer 150a, and a second electrode 160.

The first electrode 120 is formed on an upper surface of the substrate 110, and patterned through physical and chemical removal, such as dry etching, wet etching, laser, and mechanical processing, to be separated with first spaces a1 formed therein.

The first charge transport layer 130, the photoactive layer 140, and the second charge transport layer 150 are sequentially stacked on upper surfaces of the separated first electrodes 120.

The first charge transport layer 130, the photoactive layer 140, and the second charge transport layer 150 stacked on the separated first electrodes 120 are patterned through physical and chemical removal, such as dry etching, wet etching, laser, and mechanical processing, to be separated with second spaces a2 formed therein.

The functional layer 150a is stacked in the second spaces a2 formed between the separated first charge transport layers 130, the separated photoactive layers 140, and the separated second charge transport layers 150.

The second electrode 160 is stacked on upper surfaces of the separated second charge transport layers 150 and upper surfaces of separated functional layers 150a. The second electrode 160 is patterned through physical and chemical removal, such as dry etching, wet etching, laser, and mechanical processing, to be separated with third spaces a3 formed therein.

Since perovskite solar cell modules described in detail below are configured in the same manner as those according to the third embodiment described above with reference to FIG. 50 and including the substrate 110, the first electrode 120, the first charge transport layer 130, the photoactive layer 140, the second charge transport layers 150, the functional layer 150a, and the second electrode 160, a detailed description thereof will be omitted. However, when structural changes, modifications, and variations are made therein, a description thereof will be given.

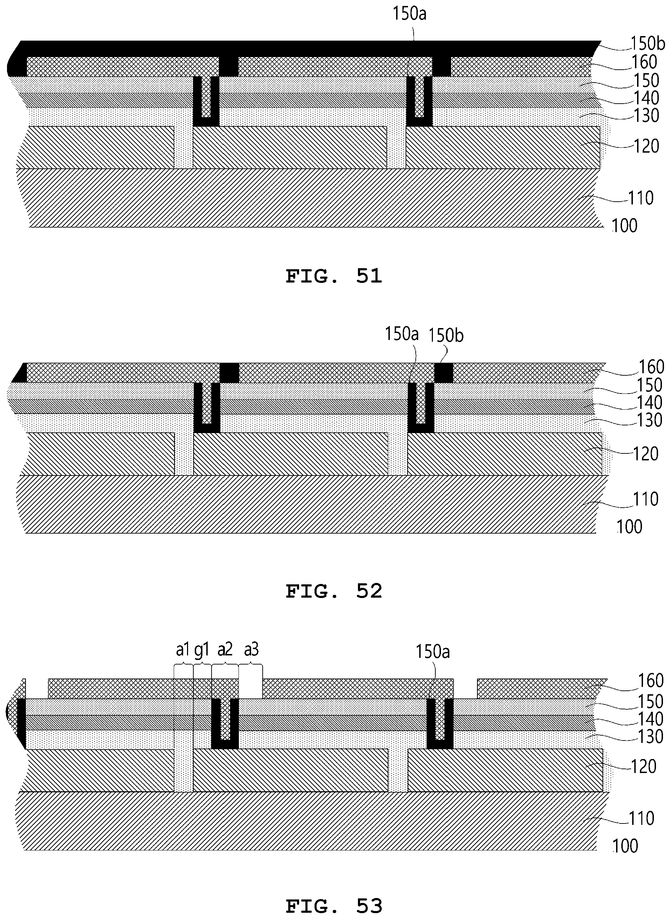

FIGS. 51 to 52 are views illustrating other examples of the perovskite solar cell module according to the third embodiment illustrated in FIG. 50.

FIG. 51 is a view illustrating a first example of the perovskite solar cell module according to the third embodiment.

As illustrated in FIG. 51, the first example of the perovskite solar cell module according to the third embodiment including a substrate 110, a first electrode 120, a first charge transport layer 130, a photoactive layer 140, a second charge transport layer 150, a functional layer 150a, and a second electrode 160 further includes a functional layer 150b. The functional layer 150b is formed on a surface of each of separated second electrodes 160, and is stacked on upper surfaces of the separated second electrodes 160 and in third spaces a3 formed between the separated second electrodes 160.

FIG. 52 is a view illustrating a second example of the perovskite solar cell module according to the third embodiment.

As illustrated in FIG. 52, the second example of the perovskite solar cell module according to the third embodiment including a substrate 110, a first electrode 120, a first charge transport layer 130, a photoactive layer 140, a second charge transport layer 150, a functional layer 150a, and a second electrode 160 further includes a functional layer 150b formed on a surface of the second electrode 160. The functional layer 150b is formed on a surface of each of separated second electrodes 160, and is stacked in third spaces a3 formed between the separated second electrodes 160.

FIG. 53 is a view illustrating a third example of the perovskite solar cell module according to the third embodiment.

As illustrated in FIG. 53, the third example of the perovskite solar cell module according to the third embodiment includes a substrate 110, a first electrode 120, a first charge transport layer 130, a photoactive layer 140, a second charge transport layer 150, a functional layer 150a, and a second electrode 160.

The first charge transport layer 130, the photoactive layer 140, and the second charge transport layer 150 are stacked on separated first electrodes 120 and patterned through physical and chemical removal, such as dry etching, wet etching, laser, and mechanical processing, to be separated with second spaces a2 formed therein. Here, the first charge transport layer 130, the photoactive layer 140, and the second charge transport layer 150 are patterned so that a first gap g1 exists between a first space a1 and a second space a2.

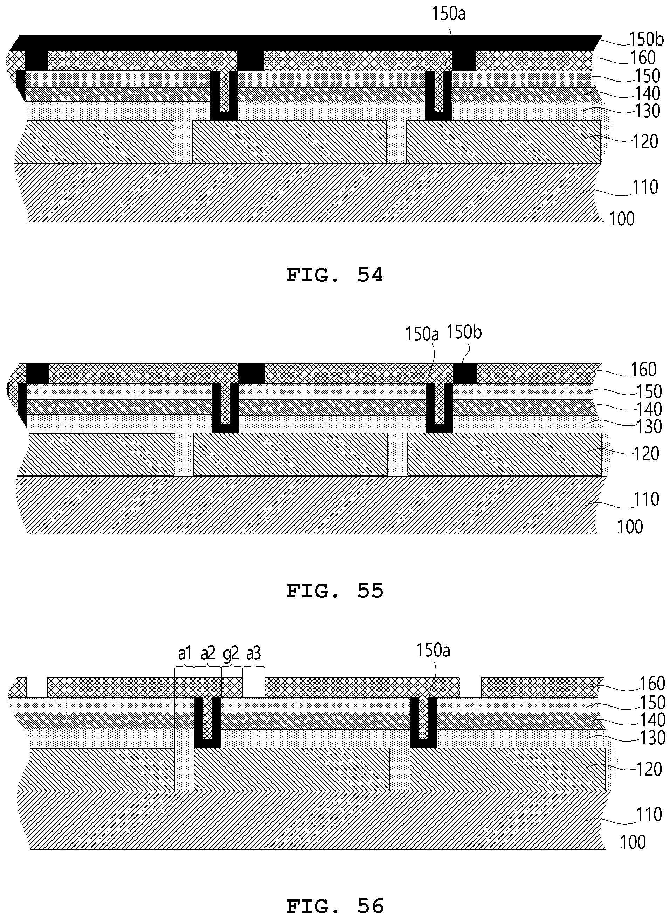

Perovskite solar cell modules modified from the third example of the perovskite solar cell module according to the third embodiment described above with reference to FIG. 53 will be described with reference to FIGS. 54 and 55.

FIG. 54 is a view illustrating a fourth example of the perovskite solar cell module according to the third embodiment.

As illustrated in FIG. 54, the fourth example of the perovskite solar cell module according to the third embodiment including a substrate 110, a first electrode 120, a first charge transport layer 130, a photoactive layer 140, a second charge transport layer 150, a functional layer 150a, and a second electrode 160 further includes a functional layer 150b. The functional layer 150b is formed on a surface of each of separated second electrodes 160, and is stacked on upper surfaces of the separated second electrodes 160 and in third spaces a3 formed between the separated second electrodes 160.

FIG. 55 is a view illustrating a fifth example of the perovskite solar cell module according to the third embodiment.

As illustrated in FIG. 55, the fifth example of the perovskite solar cell module according to the third embodiment including a substrate 110, a first electrode 120, a first charge transport layer 130, a photoactive layer 140, a second charge transport layer 150, a functional layer 150a, and a second electrode 160 further includes a functional layer 150b. The functional layer 150b is formed on a surface of each of separated second electrodes 160, and is stacked in third spaces a3 formed between the separated second electrodes 160.

FIG. 56 is a view illustrating a sixth example of the perovskite solar cell module according to the third embodiment.

As illustrated in FIG. 56, the sixth example of the perovskite solar cell module according to the third embodiment includes a substrate 110, a first electrode 120, a first charge transport layer 130, a photoactive layer 140, a second charge transport layer 150, a functional layer 150a, and a second electrode 160.

The second electrode 160 is stacked on upper surfaces of separated second charge transport layers 150 and upper surfaces of separated functional layers 150a, and patterned through physical and chemical removal, such as dry etching, wet etching, laser, and mechanical processing, to be separated with third spaces a3 formed therein. Here, the second electrode 160 is patterned so that a second gap g2 exists between a second space a2 and a third space a3.

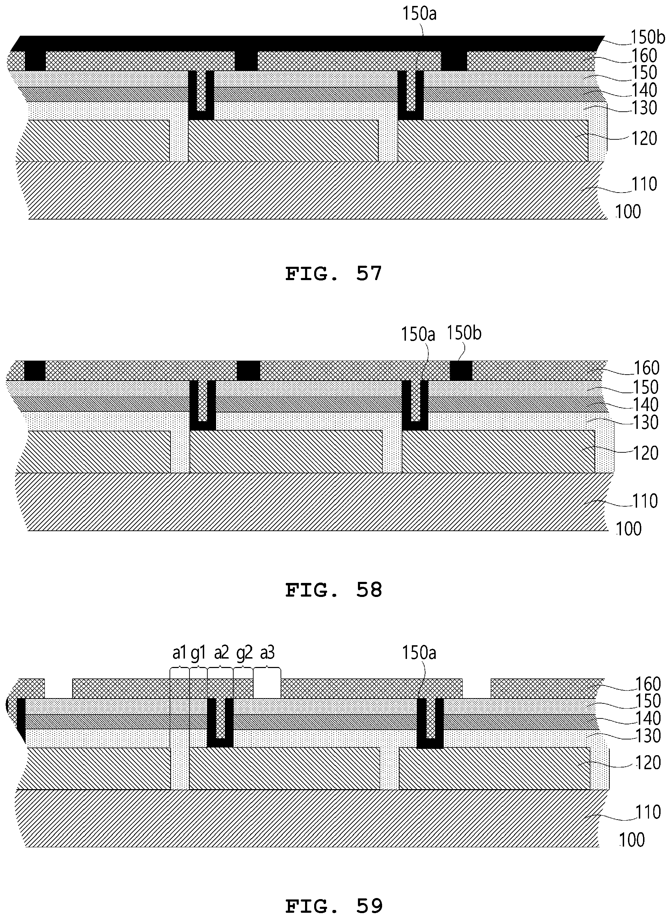

Perovskite solar cell modules modified from the sixth example of the perovskite solar cell module according to the third embodiment described above with reference to FIG. 56 will be described with reference to FIGS. 57 and 58.

FIG. 57 is a view illustrating a seventh example of the perovskite solar cell module according to the third embodiment.

As illustrated in FIG. 57, the seventh example of the perovskite solar cell module according to the third embodiment including a substrate 110, a first electrode 120, a first charge transport layer 130, a photoactive layer 140, a second charge transport layer 150, a functional layer 150a, and a second electrode 160 further includes a functional layer 150b. The functional layer 150b is formed on a surface of each of separated second electrodes 160, and is stacked on upper surfaces of the separated second electrodes 160 and in third spaces a3 formed between the separated second electrodes 160.

FIG. 58 is a view illustrating an eighth example of the perovskite solar cell module according to the third embodiment.

As illustrated in FIG. 58, the eighth example of the perovskite solar cell module according to the third embodiment including a substrate 110, a first electrode 120, a first charge transport layer 130, a photoactive layer 140, a second charge transport layer 150, a functional layer 150a, and a second electrode 160 further includes a functional layer 150b. The functional layer 150b is formed on a surface of each of separated second electrodes 160, and is stacked in third spaces a3 formed between the separated second electrodes 160.

FIG. 59 is a view illustrating a ninth example of the perovskite solar cell module according to the third embodiment.

As illustrated in FIG. 59, the ninth example of the perovskite solar cell module according to the third embodiment includes a substrate 110, a first electrode 120, a first charge transport layer 130, a photoactive layer 140, a second charge transport layer 150, a functional layer 150a, and a second electrode 160.

The first charge transport layer 130, the photoactive layer 140, and the second charge transport layer 150 are stacked on separated first electrodes 120 and patterned through physical and chemical removal, such as dry etching, wet etching, laser, and mechanical processing, to be separated with second spaces a2 formed therein. Here, the first charge transport layer 130, the photoactive layer 140, and the second charge transport layer 150 are patterned so that a first gap g1 exists between a first space a1 and a second space a2.

In addition, the second electrode 160 is stacked on upper surfaces of the separated second charge transport layers 150 and upper surfaces of separated functional layers 150a, and patterned through physical and chemical removal, such as dry etching, wet etching, laser, and mechanical processing, to be separated with third spaces a3 formed therein. Here, the second electrode 160 is patterned so that a second gap g2 exists between a second space a2 and a third space a3.

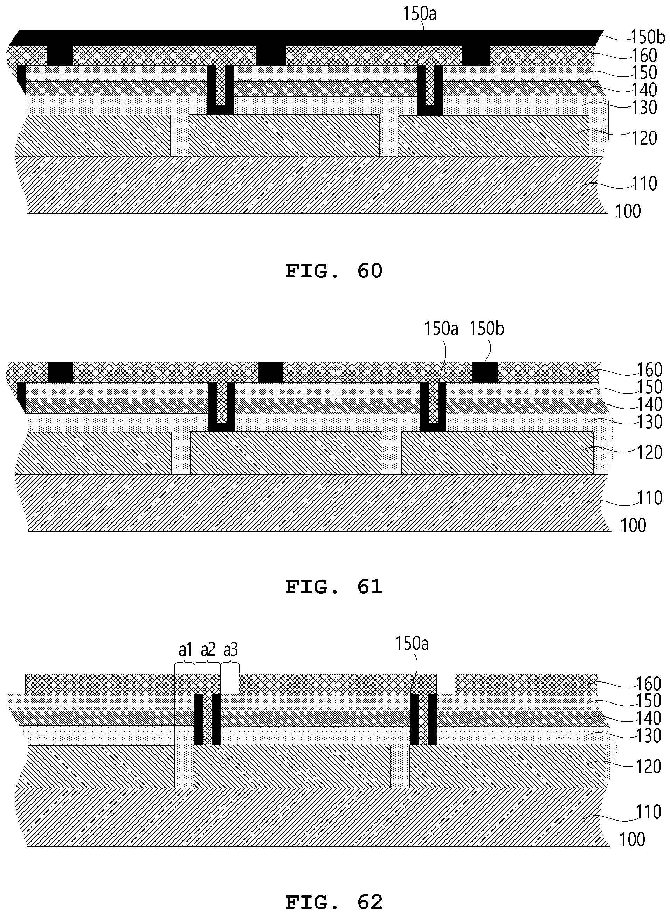

Perovskite solar cell modules modified from the ninth example of the perovskite solar cell module according to the third embodiment described above with reference to FIG. 59 will be described with reference to FIGS. 60 and 61.

FIG. 60 is a view illustrating a tenth example of the perovskite solar cell module according to the third embodiment.

As illustrated in FIG. 60, the tenth example of the perovskite solar cell module according to the third embodiment including a substrate 110, a first electrode 120, a first charge transport layer 130, a photoactive layer 140, a second charge transport layer 150, a functional layer 150a, and a second electrode 160 further includes a functional layer 150b. The functional layer 150b is stacked on upper surfaces of separated second electrodes 160 and in third spaces a3 formed between the separated second electrodes 160.

FIG. 61 is a view illustrating an eleventh example of the perovskite solar cell module according to the third embodiment.

As illustrated in FIG. 61, the eleventh example of the perovskite solar cell module according to the third embodiment including a substrate 110, a first electrode 120, a first charge transport layer 130, a photoactive layer 140, a second charge transport layer 150, a functional layer 150a, and a second electrode 160 further includes a functional layer 150b. The functional layer 150b is stacked in third spaces a3 formed between separated second electrodes 160.

FIGS. 62 to 73 are views illustrating modified structures of the first to eleventh examples of the perovskite solar cell module according to the third embodiment described above. A functional layer 150a is patterned through physical and chemical removal, such as dry etching, wet etching, laser, and mechanical processing, so that each second electrode 160 is in contact with and electrically connected to an adjacent first electrode 120.

### Fourth embodiment

FIG. 74 is a schematic view illustrating a perovskite solar cell module according to a fourth embodiment.

As illustrated in FIG. 74, the perovskite solar cell module 100 according to the fourth embodiment includes a substrate 110, a first electrode 120, a first charge transport layer 130, a photoactive layer 140, a second charge transport layer 150, a functional layer 150a, and a second electrode 160.

The first electrode 120 is stacked on an upper surface of the substrate 110, and patterned through physical and chemical removal, such as dry etching, wet etching, laser, and mechanical processing, to be separated with first spaces a1 formed therein.

The first charge transport layer 130 is stacked on upper surfaces of the separated first electrodes 120 and in the first spaces a1 formed between the separated first electrodes 120.

The photoactive layer 140 and the second charge transport layer 150 are sequentially stacked on an upper surface of the first charge transport layer 130. The first charge transport layer 130, the photoactive layer 140, and the second charge transport layer 150 stacked on the separated first electrodes 120 are patterned through physical and chemical removal, such as dry etching, wet etching, laser, and mechanical processing, to be separated with second spaces a2 formed therein.

The functional layer 150a is stacked in the second spaces a2 formed between the separated first charge transport layers 130, the separated photoactive layers 140, and the separated second charge transport layers 150.

The second electrode 160 is stacked on upper surfaces of the separated second charge transport layers 150 and upper surfaces of separated functional layers 150a. The separated first charge transport layers 130, the separated photoactive layers 140, the separated second charge transport layers 150, and the second electrode 160 stacked on the separated first electrodes 120 are patterned through physical and chemical removal, such as dry etching, wet etching, laser, and mechanical processing, to be separated with third spaces a3 formed therein.

Since perovskite solar cell modules described in detail below are configured in the same manner as those according to the fourth embodiment described above with reference to FIG. 74 and including the substrate 110, the first electrode 120, the first charge transport layer 130, the photoactive layer 140, the second charge transport layers 150, the functional layer 150a, and the second electrode 160, a detailed description thereof will be omitted. However, when structural changes, modifications, and variations are made therein, a description thereof will be given.

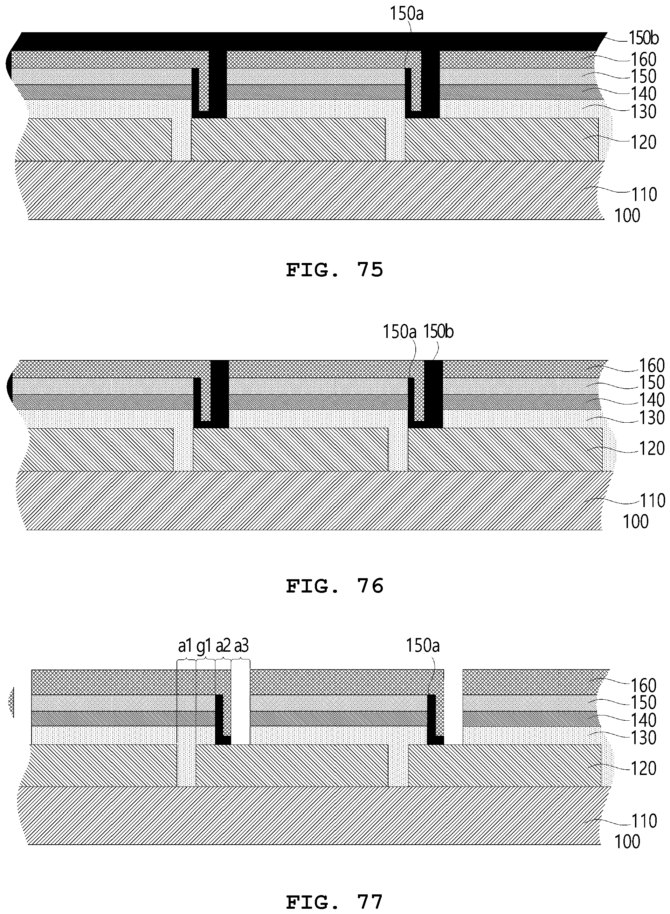

FIGS. 75 to 76 are views illustrating other examples of the perovskite solar cell module according to the fourth embodiment illustrated in FIG. 74.

FIG. 75 is a view illustrating a first example of the perovskite solar cell module according to the fourth embodiment.

As illustrated in FIG. 75, the first example of the perovskite solar cell module according to the fourth embodiment including a substrate 110, a first electrode 120, a first charge transport layer 130, a photoactive layer 140, a second charge transport layer 150, a functional layer 150a, and a second electrode 160 further includes a functional layer 150b. The functional layer 150b is formed on a surface of each of separated second electrodes 160, and is stacked on upper surfaces of the separated second electrodes 160 and in third spaces a3 formed between separated first charge transport layers 130, separated photoactive layers 140, separated second charge transport layers 150, and the separated second electrodes 160.

FIG. 76 is a view illustrating a second example of the perovskite solar cell module according to the fourth embodiment.

As illustrated in FIG. 76, the second example of the perovskite solar cell module according to the fourth embodiment including a substrate 110, a first electrode 120, a first charge transport layer 130, a photoactive layer 140, a second charge transport layer 150, a functional layer 150a, and a second electrode 160 further includes a functional layer 150b. The functional layer 150b is stacked in third spaces a3 formed between separated first charge transport layers 130, separated photoactive layers 140, separated second charge transport layers 150, and separated second electrodes 160.

FIG. 77 is a view illustrating a third example of the perovskite solar cell module according to the fourth embodiment.

As illustrated in FIG. 77, the third example of the perovskite solar cell module according to the fourth embodiment includes a substrate 110, a first electrode 120, a first charge transport layer 130, a photoactive layer 140, a second charge transport layer 150, a functional layer 150a, and a second electrode 160.

The first charge transport layer 130, the photoactive layer 140, and the second charge transport layer 150 are stacked on separated first electrodes 120 and patterned through physical and chemical removal, such as dry etching, wet etching, laser, and mechanical processing, to be separated with second spaces a2 formed therein. Here, the first charge transport layer 130, the photoactive layer 140, and the second charge transport layer 150 are patterned so that a first gap g1 exists between a first space a1 and a second space a2.

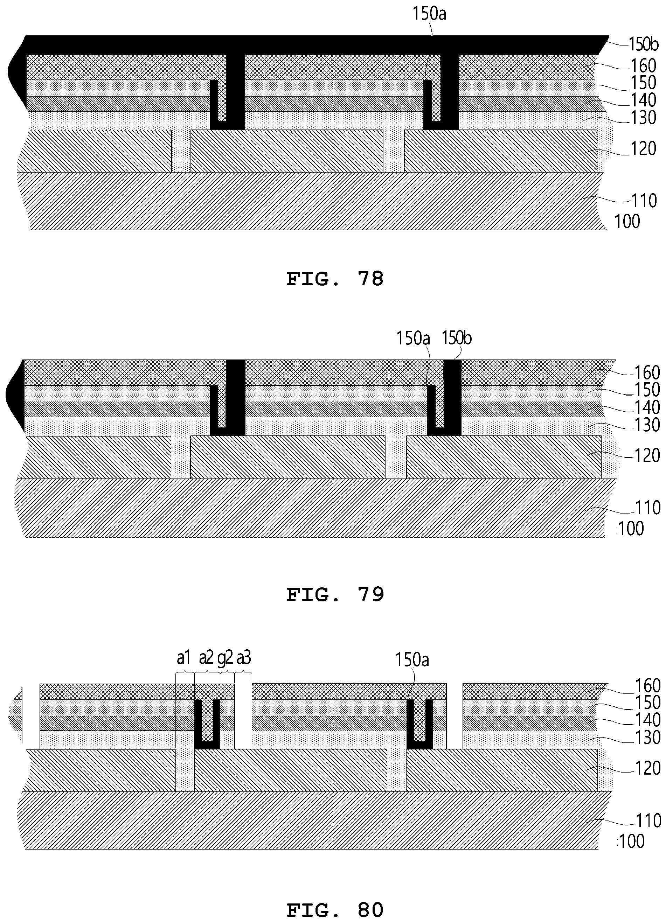

Perovskite solar cell modules modified from the third example of the perovskite solar cell module according to the fourth embodiment described above with reference to FIG. 77 will be described with reference to FIGS. 78 and 79.

FIG. 78 is a view illustrating a fourth example of the perovskite solar cell module according to the fourth embodiment.

As illustrated in FIG. 78, the fourth example of the perovskite solar cell module according to the fourth embodiment including a substrate 110, a first electrode 120, a first charge transport layer 130, a photoactive layer 140, a second charge transport layer 150, a functional layer 150a, and a second electrode 160 further includes a functional layer 150b. The functional layer 150b is formed on a surface of each of separated second electrodes 160, and is stacked on upper surfaces of the separated second electrodes 160 and in third spaces a3 formed between separated first charge transport layers 130, separated photoactive layers 140, separated second charge transport layers 150, and the separated second electrodes 160.

FIG. 79 is a view illustrating a fifth example of the perovskite solar cell module according to the fourth embodiment.

As illustrated in FIG. 79, the fifth example of the perovskite solar cell module according to the fourth embodiment including a substrate 110, a first electrode 120, a first charge transport layer 130, a photoactive layer 140, a second charge transport layer 150, a functional layer 150a, and a second electrode 160 further includes a functional layer 150b. The functional layer 150b is stacked in third spaces a3 formed between separated first charge transport layers 130, separated photoactive layers 140, separated second charge transport layers 150, and separated second electrodes 160.

FIG. 80 is a view illustrating a sixth example of the perovskite solar cell module according to the fourth embodiment.

As illustrated in FIG. 80, the sixth example of the perovskite solar cell module according to the fourth embodiment includes a substrate 110, a first electrode 120, a first charge transport layer 130, a photoactive layer 140, a second charge transport layer 150, a functional layer 150a, and a second electrode 160.

Separated first charge transport layers 130, separated photoactive layers 140, separated second charge transport layers 150, and the second electrode 160 stacked on separated first electrodes 120 are patterned through physical and chemical removal, such as dry etching, wet etching, laser, and mechanical processing, to be separated with third spaces formed therein. Here, the separated first charge transport layers 130, the separated photoactive layers 140, the separated second charge transport layers 150, and the second electrode 160 are patterned so that a second gap g2 exists between a second space a2 and a third space a3.

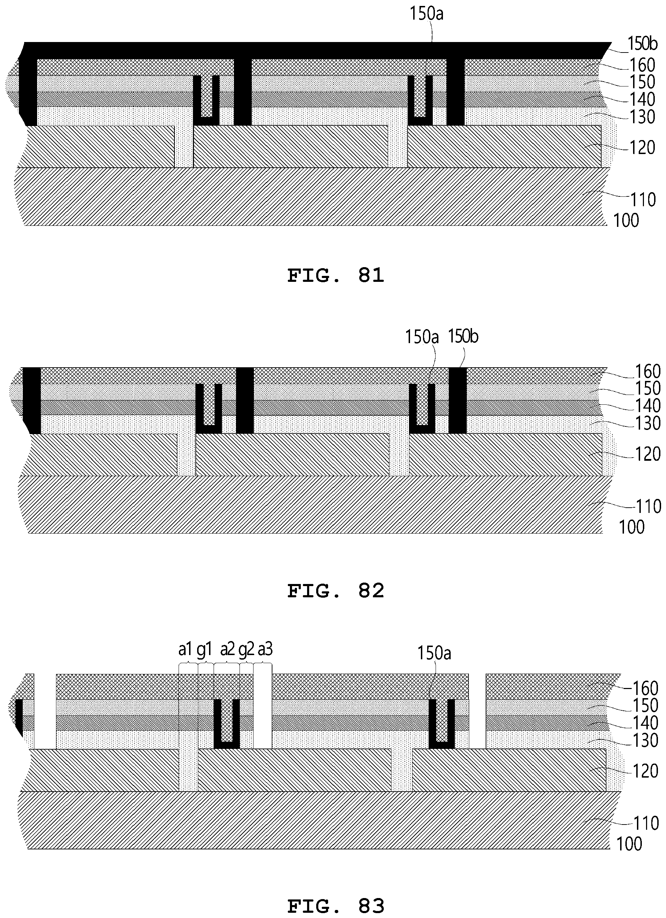

Perovskite solar cell modules modified from the sixth example of the perovskite solar cell module according to the fourth embodiment described above with reference to FIG. 80 will be described with reference to FIGS. 81 and 82.

FIG. 81 is a view illustrating a seventh example of the perovskite solar cell module according to the fourth embodiment.

As illustrated in FIG. 81, the seventh example of the perovskite solar cell module according to the fourth embodiment including a substrate 110, a first electrode 120, a first charge transport layer 130, a photoactive layer 140, a second charge transport layer 150, a functional layer 150a, and a second electrode 160 further includes a functional layer 150b. The functional layer 150b is formed on a surface of each of separated second electrodes 160, and is stacked on upper surfaces of the separated second electrodes 160 and in third spaces a3 formed between separated first charge transport layers 130, separated photoactive layers 140, separated second charge transport layers 150, and the separated second electrodes 160.

FIG. 82 is a view illustrating an eighth example of the perovskite solar cell module according to the fourth embodiment.

As illustrated in FIG. 82, the eighth example of the perovskite solar cell module according to the fourth embodiment including a substrate 110, a first electrode 120, a first charge transport layer 130, a photoactive layer 140, a second charge transport layer 150, a functional layer 150a, and a second electrode 160 further includes a functional layer 150b. The functional layer 150b is stacked in third spaces a3 formed between separated first charge transport layers 130, separated photoactive layers 140, separated second charge transport layers 150, and separated second electrodes 160.

FIG. 83 is a view illustrating a ninth example of the perovskite solar cell module according to the fourth embodiment.

As illustrated in FIG. 83, the ninth example of the perovskite solar cell module according to the fourth embodiment includes a substrate 110, a first electrode 120, a first charge transport layer 130, a photoactive layer 140, a second charge transport layer 150, a functional layer 150a, and a second electrode 160.

The first charge transport layer 130, the photoactive layer 140, and the second charge transport layer 150 are stacked on separated first electrodes 120 and patterned through physical and chemical removal, such as dry etching, wet etching, laser, and mechanical processing, to be separated with second spaces a2 formed therein. Here, the first charge transport layer 130, the photoactive layer 140, and the second charge transport layer 150 are patterned so that a first gap g1 exists between a first space a1 and a second space a2.

In addition, the separated first charge transport layers 130, the separated photoactive layers 140, the separated second charge transport layers 150, and the second electrode 160 stacked on the separated first electrodes 120 are patterned through physical and chemical removal, such as dry etching, wet etching, laser, and mechanical processing, to be separated with third spaces a3 formed therein. Here, the separated first charge transport layers 130, the separated photoactive layers 140, the separated second charge transport layers 150, and the second electrode 160 are patterned so that a second gap g2 exists between a second space a2 and a third space a3.

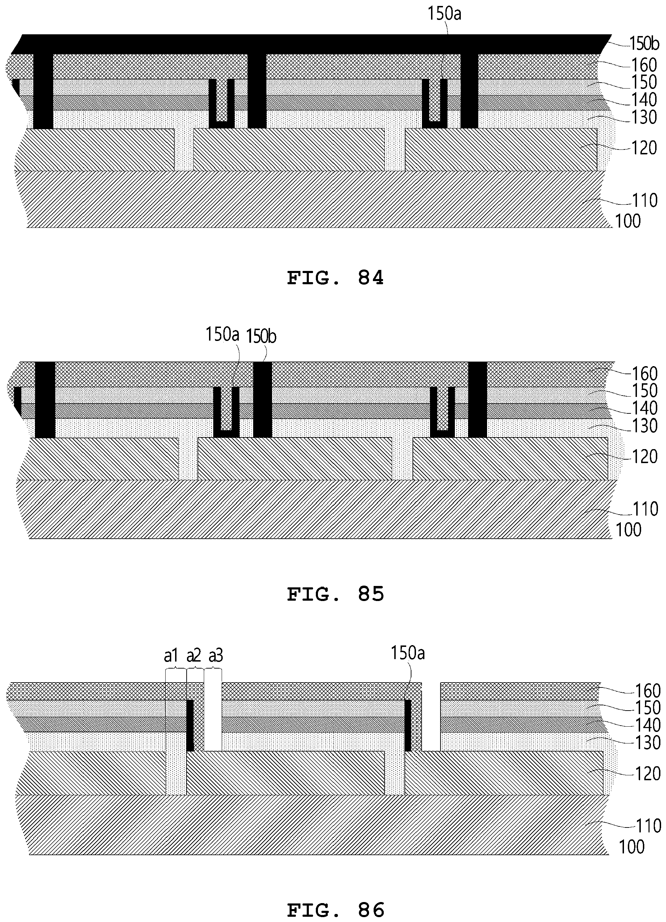

Perovskite solar cell modules modified from the ninth example of the perovskite solar cell module according to the fourth embodiment described above with reference to FIG. 83 will be described with reference to FIGS. 84 and 85.

FIG. 84 is a view illustrating a tenth example of the perovskite solar cell module according to the fourth embodiment.

As illustrated in FIG. 84, the tenth example of the perovskite solar cell module according to the fourth embodiment including a substrate 110, a first electrode 120, a first charge transport layer 130, a photoactive layer 140, a second charge transport layer 150, a functional layer 150a, and a second electrode 160 further includes a functional layer 150b. The functional layer 150b is formed on a surface of each of separated second electrodes 160, and is stacked on upper surfaces of the separated second electrodes 160 and in third spaces a3 formed between separated first charge transport layers 130, separated photoactive layers 140, separated second charge transport layers 150, and the separated second electrodes 160.

FIG. 85 is a view illustrating an eleventh example of the perovskite solar cell module according to the fourth embodiment.

As illustrated in FIG. 85, the eleventh example of the perovskite solar cell module according to the fourth embodiment including a substrate 110, a first electrode 120, a first charge transport layer 130, a photoactive layer 140, a second charge transport layer 150, a functional layer 150a, and a second electrode 160 further includes a functional layer 150b. The functional layer 150b is stacked in third spaces a3 formed between separated first charge transport layers 130, separated photoactive layers 140, separated second charge transport layers 150, and separated second electrodes 160.

FIGS. 86 to 97 are views illustrating modified structures of the first to eleventh examples of the perovskite solar cell module according to the fourth embodiment described above. A functional layer 150a is patterned through physical and chemical removal, such as dry etching, wet etching, laser, and mechanical processing, so that each second electrode 160 is in contact with and electrically connected to an adjacent first electrode 120.

### Fifth embodiment

FIG. 98 is a schematic view illustrating a perovskite solar cell module according to a fifth embodiment.

As illustrated in FIG. 98, the perovskite solar cell module 100 according to the fourth embodiment includes a substrate 110, a first electrode 120, a first charge transport layer 130, a photoactive layer 140, a second charge transport layer 150, a functional layer 150a, and a second electrode 160.

The first electrode 120 is stacked on an upper surface of the substrate 110, and patterned through physical and chemical removal, such as dry etching, wet etching, laser, and mechanical processing, to be separated with first spaces a1 formed therein.

The first charge transport layer 130 is stacked on upper surfaces of the separated first electrodes 120 and in the first spaces a1 formed between the separated first electrodes 120.

The photoactive layer 140 and the second charge transport layer 150 are sequentially stacked on an upper surface of the first charge transport layer 130. The first charge transport layer 130, the photoactive layer 140, and the second charge transport layer 150 stacked on the separated first electrodes 120 are patterned through physical and chemical removal, such as dry etching, wet etching, laser, and mechanical processing, to be separated with second spaces a2 formed therein.

The second electrode 160 is stacked on upper surfaces of the separated second charge transport layers 150 and in the second spaces a2 formed between the separated first charge transport layers 130, the separated photoactive layers 140, and the separated second charge transport layers 150. Here, the second electrode 160 is patterned through physical and chemical removal, such as dry etching, wet etching, laser, and mechanical processing, to be separated with third spaces a3 formed therein.

The functional layer 150a is stacked in the third spaces a3 formed between the separated second electrodes 160.

Since perovskite solar cell modules described in detail below are configured in the same manner as those according to the fifth embodiment described above with reference to FIG. 98 and including the substrate 110, the first electrode 120, the first charge transport layer 130, the photoactive layer 140, the second charge transport layers 150, the second electrode 160, and the functional layer 150a, a detailed description thereof will be omitted. However, when structural changes, modifications, and variations are made therein, a description thereof will be given.

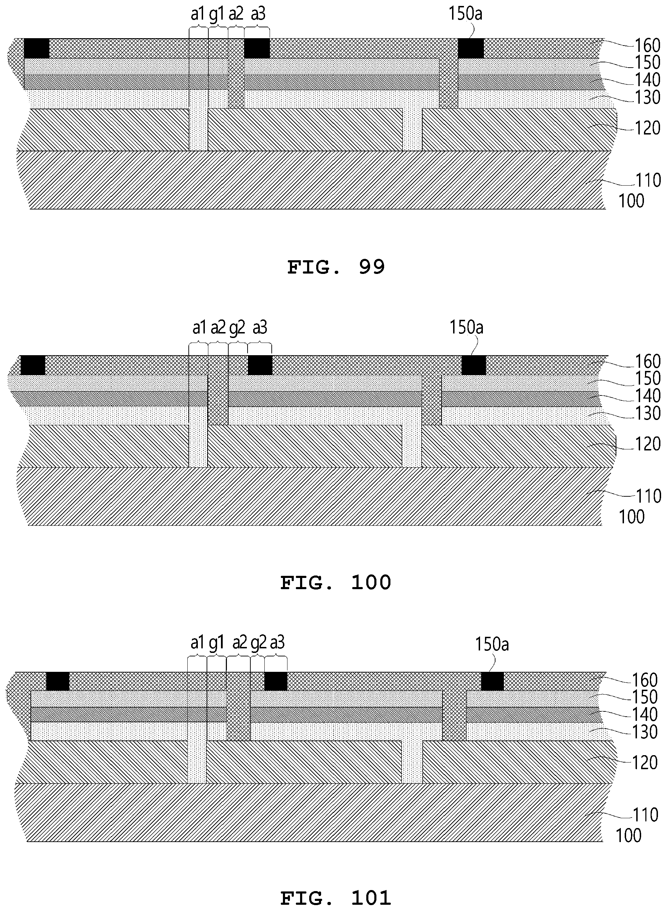

FIGS. 99 to 105 are views illustrating other examples of the perovskite solar cell module according to the fifth embodiment.

FIG. 99 is a view illustrating a first example of the perovskite solar cell module according to the fifth embodiment.

As illustrated in FIG. 99, the first example of the perovskite solar cell module according to the fifth embodiment includes a substrate 110, a first electrode 120, a first charge transport layer 130, a photoactive layer 140, a second charge transport layer 150, a functional layer 150a, and a second electrode 160.

The first charge transport layer 130, the photoactive layer 140, and the second charge transport layer 150 are stacked on separated first electrodes 120 and patterned through physical and chemical removal, such as dry etching, wet etching, laser, and mechanical processing, to be separated with second spaces a2 formed therein. Here, the first charge transport layer 130, the photoactive layer 140, and the second charge transport layer 150 are patterned so that a first gap g1 exists between a first space a1 and a second space a2.

The second electrode 160 is stacked on upper surfaces of the separated second charge transport layers 150 and in the second spaces a2 formed between the separated first charge transport layers 130, the separated photoactive layers 140, and the separated second charge transport layers 150. After that, the second electrode 160 is patterned through physical and chemical removal, such as dry etching, wet etching, laser, and mechanical processing, to be separated with third spaces a3 formed therein.

The functional layer 150a is stacked in the third spaces a3 formed between the separated second electrodes 160.

FIG. 100 is a view illustrating a second example of the perovskite solar cell module according to the fifth embodiment.

As illustrated in FIG. 100, the second example of the perovskite solar cell module according to the fifth embodiment includes a substrate 110, a first electrode 120, a first charge transport layer 130, a photoactive layer 140, a second charge transport layer 150, a functional layer 150a, and a second electrode 160.

The first charge transport layer 130, the photoactive layer 140, and the second charge transport layer 150 are stacked on separated first electrodes 120 and patterned through physical and chemical removal, such as dry etching, wet etching, laser, and mechanical processing, to be separated with second spaces a2 formed therein. In addition, the second electrode 160 is stacked on upper surfaces of the separated second charge transport layers 150 and in the second spaces a2 formed on the separated first electrodes 120. After that, the second electrode 160 is patterned through physical and chemical removal, such as dry etching, wet etching, laser, and mechanical processing, to be separated with third spaces a3 formed therein. Here, the second electrode 160 is patterned so that a second gap g2 exists between a second space a2 and a third space a3.

The functional layer 150a is stacked in the third spaces a3 formed between the separated second electrodes 160.

FIG. 101 is a view illustrating a third example of the perovskite solar cell module according to the fifth embodiment.

As illustrated in FIG. 101, the third example of the perovskite solar cell module according to the fifth embodiment includes a substrate 110, a first electrode 120, a first charge transport layer 130, a photoactive layer 140, a second charge transport layer 150, a functional layer 150a, and a second electrode 160.

The first charge transport layer 130, the photoactive layer 140, and the second charge transport layer 150 are stacked on separated first electrodes 120 and patterned through physical and chemical removal, such as dry etching, wet etching, laser, and mechanical processing, to be separated with second spaces a2 formed therein. Here, the first charge transport layer 130, the photoactive layer 140, and the second charge transport layer 150 are patterned so that a first gap g1 exists between a first space a1 and a second space a2.

In addition, the second electrode 160 is stacked on upper surfaces of the separated second charge transport layers 150 and in the second spaces a2 formed on the separated first electrodes 120. After that, the second electrode 160 is patterned through physical and chemical removal, such as dry etching, wet etching, laser, and mechanical processing, to be separated with third spaces a3 formed therein. Here, the second electrode 160 is patterned so that a second gap g2 exists between a second space a2 and a third space a3.

The functional layer 150a is stacked in the third spaces a3 formed between the second electrodes 160.

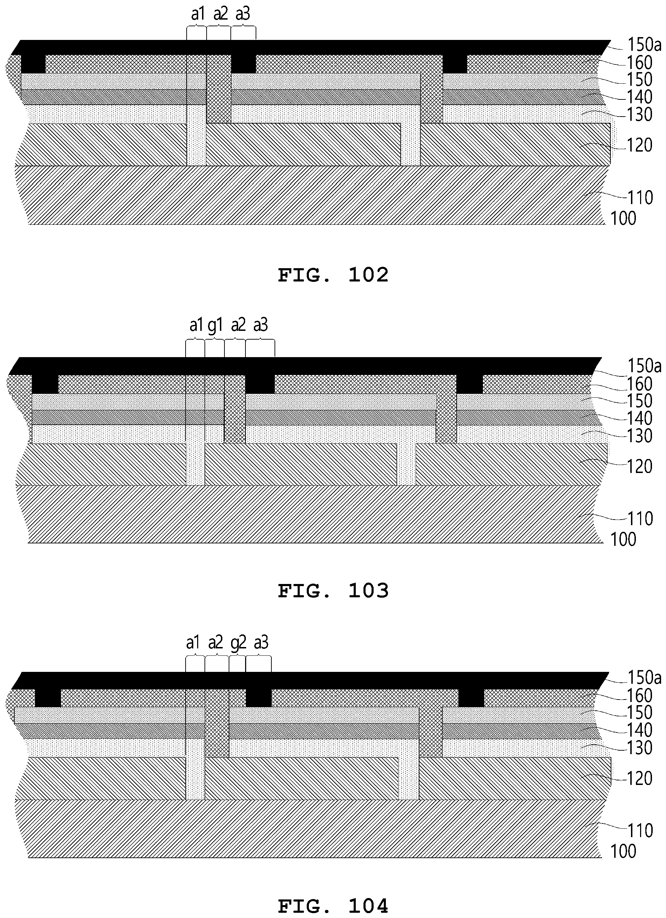

FIG. 102 is a view illustrating a fourth example of the perovskite solar cell module according to the fifth embodiment.

As illustrated in FIG. 102, the fourth example of the perovskite solar cell module according to the fifth embodiment including a substrate 110, a first electrode 120, a first charge transport layer 130, a photoactive layer 140, a second charge transport layer 150, and a second electrode 160 further includes a functional layer 150a. The functional layer 150a is formed on a surface of each of separated second electrodes 160, and is stacked on upper surfaces of the separated second electrodes 160 and in third spaces a3 formed between the separated second electrodes 160.

FIG. 103 is a view illustrating a fifth example of the perovskite solar cell module according to the fifth embodiment.

As illustrated in FIG. 103, the fifth example of the perovskite solar cell module according to the fifth embodiment includes a substrate 110, a first electrode 120, a first charge transport layer 130, a photoactive layer 140, a second charge transport layer 150, a second electrode 160, and a functional layer 150a.

The first charge transport layer 130, the photoactive layer 140, and the second charge transport layer 150 are stacked on separated first electrodes 120 and patterned through physical and chemical removal, such as dry etching, wet etching, laser, and mechanical processing, to be separated with second spaces a2 formed therein. Here, the first charge transport layer 130, the photoactive layer 140, and the second charge transport layer 150 are patterned so that a first gap g1 exists between a first space a1 and a second space a2.

The second electrode 160 is stacked on upper surfaces of the separated second charge transport layers 150 and in the second spaces a2 formed between the separated first charge transport layers 130, the separated photoactive layers 140, and the separated second charge transport layers 150. After that, the second electrode 160 is patterned through physical and chemical removal, such as dry etching, wet etching, laser, and mechanical processing, to be separated with third spaces a3 formed therein.

The functional layer 150a is stacked on upper surfaces of the separated second electrodes 160 and in the third spaces a3 formed between the separated second electrodes 160.

FIG. 104 is a view illustrating a sixth example of the perovskite solar cell module according to the fifth embodiment.

As illustrated in FIG. 103, the sixth example of the perovskite solar cell module according to the fifth embodiment includes a substrate 110, a first electrode 120, a first charge transport layer 130, a photoactive layer 140, a second charge transport layer 150, a second electrode 160, and a functional layer 150a.

The first charge transport layer 130, the photoactive layer 140, and the second charge transport layer 150 are stacked on separated first electrodes 120 and patterned through physical and chemical removal, such as dry etching, wet etching, laser, and mechanical processing, to be separated with second spaces a2 formed therein.

In addition, the second electrode 160 is stacked on upper surfaces of the separated second charge transport layers 150 and in the second spaces a2 formed on the separated first electrodes 120. After that, the second electrode 160 is patterned through physical and chemical removal, such as dry etching, wet etching, laser, and mechanical processing, to be separated with third spaces a3 formed therein. Here, the second electrode 160 is patterned so that a second gap g2 exists between a second space a2 and a third space a3.

The functional layer 150a is stacked on upper surfaces of the separated second electrodes 160 and in the third spaces a3 formed between the separated second electrodes 160.

FIG. 105 is a view illustrating a seventh example of the perovskite solar cell module according to the fifth embodiment.

As illustrated in FIG. 105, the seventh example of the perovskite solar cell module according to the fifth embodiment includes a substrate 110, a first electrode 120, a first charge transport layer 130, a photoactive layer 140, a second charge transport layer 150, a second electrode 160, and a functional layer 150a.

The first charge transport layer 130, the photoactive layer 140, and the second charge transport layer 150 are stacked on separated first electrodes 120 and patterned through physical and chemical removal, such as dry etching, wet etching, laser, and mechanical processing, to be separated with second spaces a2 formed therein. Here, the first charge transport layer 130, the photoactive layer 140, and the second charge transport layer 150 are patterned so that a first gap g1 exists between a first space a1 and a second space a2.

In addition, the second electrode 160 is stacked on upper surfaces of the separated second charge transport layers 150 and in the second spaces a2 formed on the separated first electrodes 120. After that, the second electrode 160 is patterned through physical and chemical removal, such as dry etching, wet etching, laser, and mechanical processing, to be separated with third spaces a3 formed therein. Here, the second electrode 160 is patterned so that a second gap g2 exists between a second space a2 and a third space a3.

The functional layer 150a is stacked on upper surfaces of the separated second electrodes 160 and in the third spaces a3 formed between the separated second electrodes 160.

### Sixth embodiment

FIG. 106 is a schematic view illustrating a perovskite solar cell module according to a sixth embodiment.

As illustrated in FIG. 106, the perovskite solar cell module 100 according to the sixth embodiment includes a substrate 110, a first electrode 120, a first charge transport layer 130, a photoactive layer 140, a second charge transport layer 150, a second electrode 160, and a functional layer 150a.

The first charge transport layer 130, the photoactive layer 140, and the second charge transport layer 150 are stacked on separated first electrodes 120 and patterned through physical and chemical removal, such as dry etching, wet etching, laser, and mechanical processing, to be separated with second spaces a2 formed therein.

The second electrode 160 is stacked on upper surfaces of the separated second charge transport layers 150 and in the second spaces a2 formed between the separated first charge transport layers 130, the separated photoactive layers 140, and the separated second charge transport layers 150. The separated first charge transport layers 130, the separated photoactive layers 140, the separated second charge transport layers 150, and the second electrode 160 stacked on the separated first electrodes 120 are patterned through physical and chemical removal, such as dry etching, wet etching, laser, and mechanical processing, to be separated with third spaces a3 formed therein.

The functional layer 150a is stacked in the third spaces a3 formed between the separated first charge transport layers 130, the separated photoactive layers 140, the separated second charge transport layers 150, and the separated second electrodes 160 stacked on the separated first electrodes 120.

Since perovskite solar cell modules described in detail below are configured in the same manner as those according to the sixth embodiment described above with reference to FIG. 106 and including the substrate 110, the first electrode 120, the first charge transport layer 130, the photoactive layer 140, the second charge transport layers 150, the second electrode 160, and the functional layer 150a, a detailed description thereof will be omitted. However, when structural changes, modifications, and variations are made therein, a description thereof will be given.

FIGS. 107 to 113 are views illustrating other examples of the perovskite solar cell module according to the sixth embodiment illustrated in FIG. 106.

FIG. 107 is a view illustrating a first example of the perovskite solar cell module according to the sixth embodiment.

As illustrated in FIG. 107, the first example of the perovskite solar cell module according to the sixth embodiment includes a substrate 110, a first electrode 120, a first charge transport layer 130, a photoactive layer 140, a second charge transport layer 150, a second electrode 160, and a functional layer 150a.

The first charge transport layer 130, the photoactive layer 140, and the second charge transport layer 150 are stacked on separated first electrodes 120 and patterned through physical and chemical removal, such as dry etching, wet etching, laser, and mechanical processing, to be separated with second spaces a2 formed therein. Here, the first charge transport layer 130, the photoactive layer 140, and the second charge transport layer 150 are patterned so that a first gap g1 exists between a first space a1 and a second space a2.

The second electrode 160 is stacked on upper surfaces of the separated second charge transport layers 150 and in the second spaces a2 formed between the separated first charge transport layers 130, the separated photoactive layers 140, and the separated second charge transport layers 150. The separated first charge transport layers 130, the separated photoactive layers 140, the separated second charge transport layers 150, and the second electrode 160 stacked on the separated first electrodes 120 are patterned through physical and chemical removal, such as dry etching, wet etching, laser, and mechanical processing, to be separated with third spaces a3 formed therein.

The functional layer 150a is stacked in the third spaces a3 formed between the separated first charge transport layers 130, the separated photoactive layers 140, the separated second charge transport layers 150, and the separated second electrodes 160 stacked on the separated first electrodes 120.

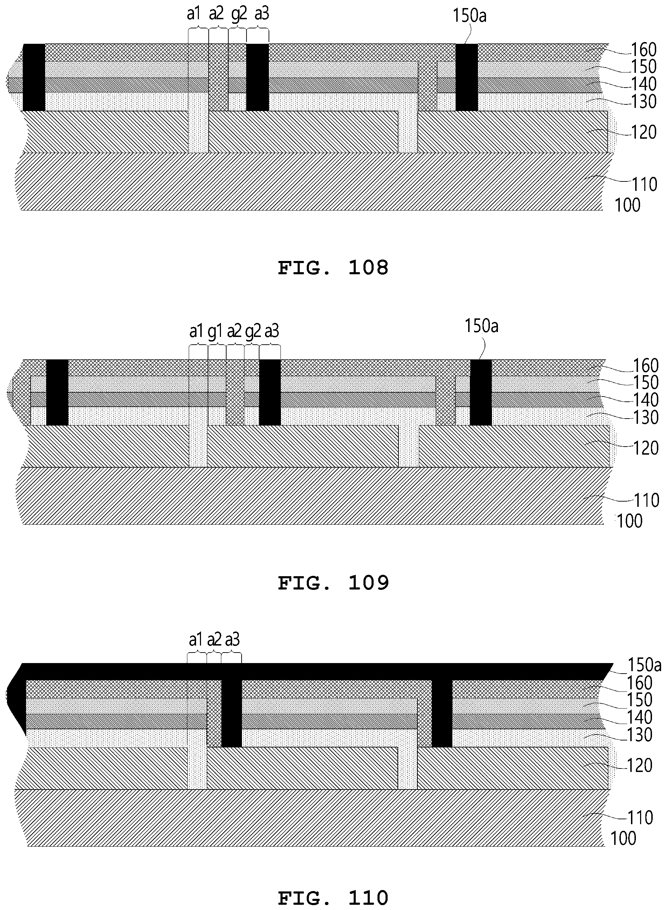

FIG. 108 is a view illustrating a second example of the perovskite solar cell module according to the sixth embodiment.

As illustrated in FIG. 108, the second example of the perovskite solar cell module according to the sixth embodiment includes a substrate 110, a first electrode 120, a first charge transport layer 130, a photoactive layer 140, a second charge transport layer 150, a second electrode 160, and a functional layer 150a.

The first charge transport layer 130, the photoactive layer 140, and the second charge transport layer 150 are stacked on separated first electrodes 120 and patterned through physical and chemical removal, such as dry etching, wet etching, laser, and mechanical processing, to be separated with second spaces a2 formed therein.

The second electrode 160 is stacked on upper surfaces of the separated second charge transport layers 150 and in the second spaces a2 formed between the separated first charge transport layers 130, the separated photoactive layers 140, and the separated second charge transport layers 150. The separated first charge transport layers 130, the separated photoactive layers 140, the separated second charge transport layers 150, and the second electrode 160 stacked on the separated first electrodes 120 are patterned through physical and chemical removal, such as dry etching, wet etching, laser, and mechanical processing, to be separated with third spaces a3 formed therein. Here, the separated first charge transport layers 130, the separated photoactive layers 140, the separated second charge transport layers 150, and the second electrode 160 are patterned so that a second gap g2 exists between a second space a2 and a third space a3.

The functional layer 150a is stacked in the third spaces a3.

FIG. 109 is a view illustrating a third example of the perovskite solar cell module according to the sixth embodiment.

As illustrated in FIG. 109, the third example of the perovskite solar cell module according to the sixth embodiment includes a substrate 110, a first electrode 120, a first charge transport layer 130, a photoactive layer 140, a second charge transport layer 150, a second electrode 160, and a functional layer 150a.

The first charge transport layer 130, the photoactive layer 140, and the second charge transport layer 150 are stacked on separated first electrodes 120 and patterned through physical and chemical removal, such as dry etching, wet etching, laser, and mechanical processing, to be separated with second spaces a2 formed therein. Here, the first charge transport layer 130, the photoactive layer 140, and the second charge transport layer 150 are patterned so that a first gap g1 exists between a first space a1 and a second space a2.

The second electrode 160 is stacked on upper surfaces of the separated second charge transport layers 150 and in the second spaces a2 formed between the separated first charge transport layers 130, the separated photoactive layers 140, and the separated second charge transport layers 150. The separated first charge transport layers 130, the separated photoactive layers 140, the separated second charge transport layers 150, and the second electrode 160 stacked on the separated first electrodes 120 are patterned through physical and chemical removal, such as dry etching, wet etching, laser, and mechanical processing, to be separated with third spaces a3 formed therein. Here, the separated first charge transport layers 130, the separated photoactive layers 140, the separated second charge transport layers 150, and the second electrode 160 are patterned so that a second gap g2 exists between a second space a2 and a third space a3.

The functional layer 150a is stacked in the third spaces a3 formed between the separated first charge transport layers 130, the separated photoactive layers 140, the separated second charge transport layers 150, and the separated second electrodes 160 stacked on the separated first electrodes 120.

FIG. 110 is a view illustrating a fourth example of the perovskite solar cell module according to the sixth embodiment.

As illustrated in FIG. 110, the fourth example of the perovskite solar cell module according to the sixth embodiment includes a substrate 110, a first electrode 120, a first charge transport layer 130, a photoactive layer 140, a second charge transport layer 150, a second electrode 160, and a functional layer 150a.

The first charge transport layer 130, the photoactive layer 140, and the second charge transport layer 150 are stacked on separated first electrodes 120 and patterned through physical and chemical removal, such as dry etching, wet etching, laser, and mechanical processing, to be separated with second spaces a2 formed therein.

The second electrode 160 is stacked on upper surfaces of the separated second charge transport layers 150 and in the second spaces a2 formed between the separated first charge transport layers 130, the separated photoactive layers 140, and the separated second charge transport layers 150. The separated first charge transport layers 130, the separated photoactive layers 140, the separated second charge transport layers 150, and the second electrode 160 stacked on the separated first electrodes 120 are patterned through physical and chemical removal, such as dry etching, wet etching, laser, and mechanical processing, to be separated with third spaces a3 formed therein.

The functional layer 150a is stacked on upper surfaces of the separated second electrodes 160 and in the third spaces a3 formed between the separated first charge transport layers 130, the separated photoactive layers 140, the separated second charge transport layers 150, and the separated second electrodes 160.

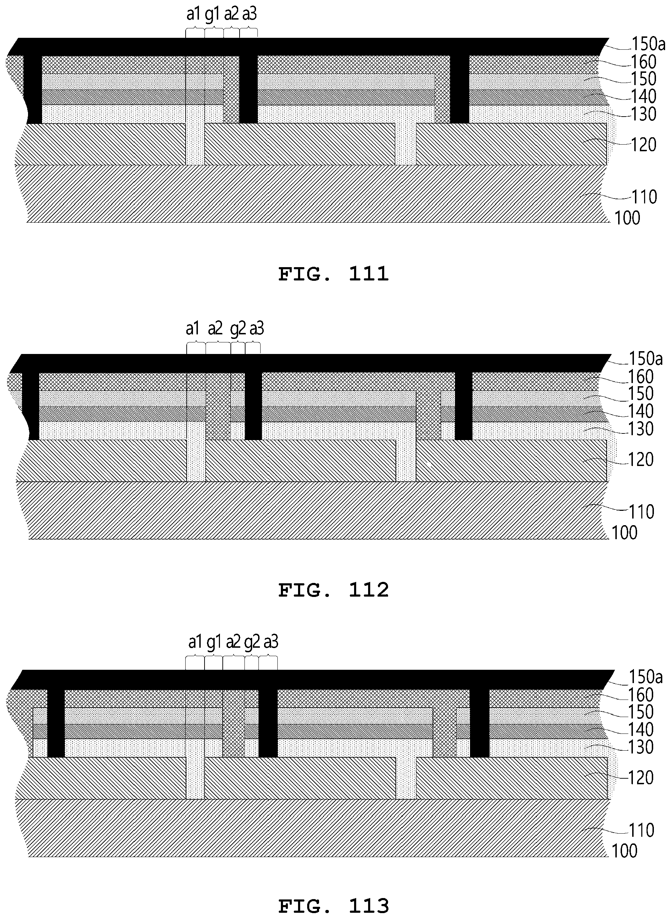

FIG. 111 is a view illustrating a fifth example of the perovskite solar cell module according to the sixth embodiment.

As illustrated in FIG. 111, the fifth example of the perovskite solar cell module according to the sixth embodiment includes a substrate 110, a first electrode 120, a first charge transport layer 130, a photoactive layer 140, a second charge transport layer 150, a second electrode 160, and a functional layer 150a.

The first charge transport layer 130, the photoactive layer 140, and the second charge transport layer 150 are stacked on separated first electrodes 120 and patterned through physical and chemical removal, such as dry etching, wet etching, laser, and mechanical processing, to be separated with second spaces a2 formed therein. Here, the first charge transport layer 130, the photoactive layer 140, and the second charge transport layer 150 are patterned so that a first gap g1 exists between a first space a1 and a second space a2.

The second electrode 160 is stacked on upper surfaces of the separated second charge transport layers 150 and in the second spaces a2 formed between the separated first charge transport layers 130, the separated photoactive layers 140, and the separated second charge transport layers 150. The separated first charge transport layers 130, the separated photoactive layers 140, the separated second charge transport layers 150, and the second electrode 160 stacked on the separated first electrodes 120 are patterned through physical and chemical removal, such as dry etching, wet etching, laser, and mechanical processing, to be separated with third spaces a3 formed therein.

The functional layer 150a is stacked on upper surfaces of the separated second electrodes 160 and in the third spaces a3 formed between the separated first charge transport layers 130, the separated photoactive layers 140, the separated second charge transport layers 150, and the separated second electrodes 160.

FIG. 112 is a view illustrating a sixth example of the perovskite solar cell module according to the sixth embodiment.

As illustrated in FIG. 112, the sixth example of the perovskite solar cell module according to the sixth embodiment includes a substrate 110, a first electrode 120, a first charge transport layer 130, a photoactive layer 140, a second charge transport layer 150, a second electrode 160, and a functional layer 150a.

The first charge transport layer 130, the photoactive layer 140, and the second charge transport layer 150 are stacked on separated first electrodes 120 and patterned through physical and chemical removal, such as dry etching, wet etching, laser, and mechanical processing, to be separated with second spaces a2 formed therein.

The second electrode 160 is stacked on upper surfaces of the separated second charge transport layers 150 and in the second spaces a2 formed between the separated first charge transport layers 130, the separated photoactive layers 140, and the separated second charge transport layers 150. The separated first charge transport layers 130, the separated photoactive layers 140, the separated second charge transport layers 150, and the second electrode 160 stacked on the separated first electrodes 120 are patterned through physical and chemical removal, such as dry etching, wet etching, laser, and mechanical processing, to be separated with third spaces a3 formed therein. Here, the separated first charge transport layers 130, the separated photoactive layers 140, the separated second charge transport layers 150, and the second electrode 160 are patterned so that a second gap g2 exists between a second space a2 and a third space a3.

The functional layer 150a is stacked on upper surfaces of the separated second electrodes 160 and in the third spaces a3 formed between the separated first charge transport layers 130, the separated photoactive layers 140, the separated second charge transport layers 150, and the separated second electrodes 160.

FIG. 113 is a view illustrating a seventh example of the perovskite solar cell module according to the sixth embodiment.

As illustrated in FIG. 113, the seventh example of the perovskite solar cell module according to the sixth embodiment includes a substrate 110, a first electrode 120, a first charge transport layer 130, a photoactive layer 140, a second charge transport layer 150, a second electrode 160, and a functional layer 150a.

The first charge transport layer 130, the photoactive layer 140, and the second charge transport layer 150 are stacked on separated first electrodes 120 and patterned through physical and chemical removal, such as dry etching, wet etching, laser, and mechanical processing, to be separated with second spaces a2 formed therein. Here, the first charge transport layer 130, the photoactive layer 140, and the second charge transport layer 150 are patterned so that a first gap g1 exists between a first space a1 and a second space a2.

The second electrode 160 is stacked on upper surfaces of the separated second charge transport layers 150 and in the second spaces a2 formed between the separated first charge transport layers 130, the separated photoactive layers 140, and the separated second charge transport layers 150. The separated first charge transport layers 130, the separated photoactive layers 140, the separated second charge transport layers 150, and the second electrode 160 stacked on the separated first electrodes 120 are patterned through physical and chemical removal, such as dry etching, wet etching, laser, and mechanical processing, to be separated with third spaces a3 formed therein. Here, the separated first charge transport layers 130, the separated photoactive layers 140, the separated second charge transport layers 150, and the second electrode 160 are patterned so that a second gap g2 exists between a second space a2 and a third space a3.

The functional layer 150a is stacked on upper surfaces of the separated second electrodes 160 and in the third spaces a3 formed on the separated first electrodes 120.

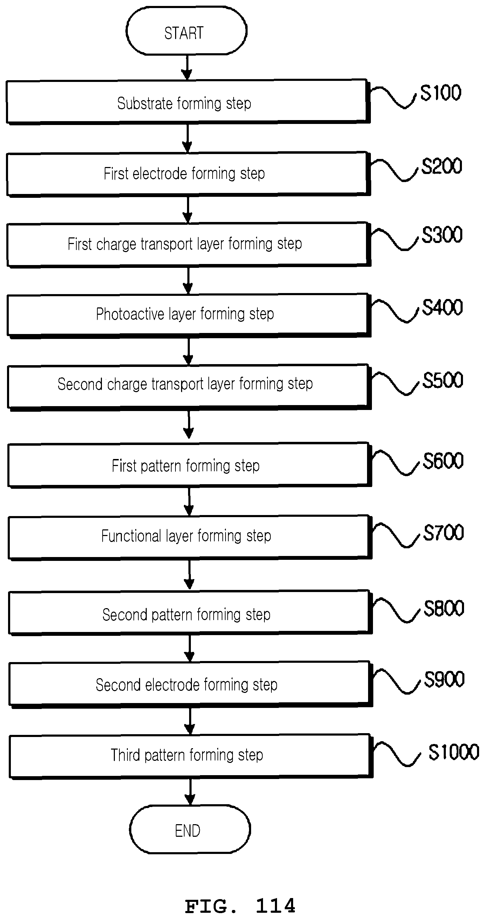

FIG. 114 is a flowchart illustrating a manufacturing method for a perovskite solar cell module according to an embodiment.

As illustrated in FIG. 114, the manufacturing method for the perovskite solar cell module according to the embodiment includes a substrate forming step (S100), a first electrode forming step (S200), a first charge transport layer forming step (S300), a photoactive layer forming step (S400), a second charge transport layer forming step (S500), a functional layer forming step (S700), and a second electrode forming step (S900). The manufacturing sequence of the perovskite solar cell module illustrated in FIG. 114 is exemplary and should not be construed as being limited thereto.

In the substrate forming step (110), a substrate 110 may be made of a material selected from the group consisting of glass, polyethylene terephthalate (PET), polyethylene naphthalate (PEN), polyethersulfone (PES), polyimide (PI), crystalline silicon, and amorphous silicon, but is not limited thereto.

In the first electrode forming step (S200), a first electrode 120 may be made of a material selected from ITO, FTO, IZO, AZO, ZnO, MoO₃, CoO, WoO₃, IGZO, IZTO, Al, Ag, Cu, PEDOT:PSS, and Au, but is not limited thereto. The first electrode 120 may be formed using a sputter, a thermal evaporator, and chemical vapor deposition (CVD), but is not limited thereto. Then, the first electrode 120 is patterned through physical and chemical removal, such as dry etching, wet etching, laser, and mechanical processing, to be first spaces a1 formed therein.

In the first charge transport layer forming step (S300), a first charge transport layer 130 may be provided as at least one layer, and may be made of any one of materials having electron transport, hole transport, electron blocking, and hole blocking functions. Here, the materials having the function of electron transport, electron blocking, hole transport, and hole blocking are defined by a role according to the energy level of the materials. The first charge transport layer 130 is stacked on upper surfaces of the separated first electrodes 120 and between the separated first electrodes 120. The first charge transport layer 130 may be formed by thermal evaporation, spin coating, slot die coating, spray coating, ink-jet coating, shearing coating, or the like, but is not limited thereto.

In the photoactive layer forming step (S400), a photoactive layer 140 is made of a material having a chemical composition of AMX₃. Here, A may be at least one metal element or organic compound, M may be any one of metal atoms, and X may be an oxide or a combination of any one or more of halogen atoms of chlorine (Cl), bromine (Br), and iodine (I). The photoactive layer 140 excites electrons maintained in a stable state inside the material by absorbing sunlight and transfers the excited electrons and holes formed due to the excited electrons to corresponding charge transport layers. In addition, the photoactive layer 140 may be formed by thermal evaporation, spin coating, slot die coating, spray coating, ink-jet coating, shearing coating, or the like, but is not limited thereto.

In the second charge transport layer forming step (S500), a second charge transport layer 150 is stacked on the photoactive layer 140. The second charge transport layer 150 may be provided as at least one layer, and may be made of any one of materials having electron transport, hole transport, electron blocking, and hole blocking functions. In addition, the second charge transport layer 150 may be formed by thermal evaporation, spin coating, slot die coating, spray coating, ink-jet coating, shearing coating, or the like, but is not limited thereto. The first charge transport layer 130 and the second charge transport layer 150 may be made of materials having opposite functions.

The manufacturing method according to the present disclosure may further include a first pattern forming step (S600). In the first pattern forming step (S600), the first charge transport layer 130, the photoactive layer 140, and the second charge transport layer 150 stacked on the separated first electrodes 120 are patterned through physical and chemical removal, such as dry etching, wet etching, laser, and mechanical processing, to be separated with second spaces a2 formed therein so that a second electrode 160 of each cell is electrically connected in series to a first electrode 120 of a nearest cell.

In the functional layer forming step (S700), a functional layer 150a may be made of a non-metal-based material formed by combining at least one or more of hydrogen (H), carbon (C), nitrogen (N), oxygen (O), fluorine (F), neon (Ne), phosphorus (P), sulfur (S), chlorine (Cl), argon (Ar), selenium (Se), bromine (Br), krypton (Kr), iodine (I), xenon (Xe), radon (Rn), and astatine (At ), but is not limited thereto. The functional layer 150a is stacked on upper surfaces of the separated second charge transport layers 150 and between the separated first charge transport layers 130, the separated photoactive layers 140, and the separated second charge transport layers 150 stacked on the separated first electrodes 120, thereby reducing interfacial resistance and blocking penetration of external moisture and oxygen.

The manufacturing method according to the present disclosure may further include a second pattern forming step (S800). In the second pattern forming step (S800), the functional layer 150a is partially patterned at positions corresponding to the second spaces a2 formed between the separated first charge transport layers 130, the separated photoactive layers 140, and the separated second charge transport layers 150 through dry etching, wet etching, laser, and mechanical processing, to be separated with predetermined spaces formed therein so that the second electrode 160 of each cell is in contact with the first electrode 120 of the nearest cell.

In the second electrode forming step (S900), a second electrode 160 is formed on an upper surface of the functional layer 150a. The second electrode 160 may be made of at least one material selected from ITO, FTO, IZO, AZO, SnO₂, In₂O₃, ZnO, MoO₃, CoO, NiO, WoO₃, TiO₂, IGZO, IZTO, Cu, Al, Ag, and Au, but is not limited thereto.

The manufacturing method according to the present disclosure may further include a third pattern forming step (S1000). In the third pattern forming step (S1000), the second electrode 160 is patterned through physical and chemical removal, such as dry etching, wet etching, laser, and mechanical processing, to be separated with third spaces a3 formed therein.

Although exemplary embodiments of the present disclosure have been described for illustrative purposes, those skilled in the art will appreciate that the present disclosure can be modified in various forms without departing from the technical spirit of the present disclosure. Therefore, the scope of the present disclosure should be determined on the basis of the descriptions in the appended claims, not any specific embodiment, and all equivalents thereof belong to the scope of the present disclosure.

## Claims

1. A perovskite solar cell module comprising a plurality of perovskite solar cells disposed on a substrate, each of the perovskite solar cells comprising: a first electrode; a first charge transport layer stacked on the first electrode; a photoactive layer stacked on the first charge transport layer and made of a perovskite material; a second charge transport layer stacked on the photoactive layer; and a second electrode stacked on the second charge transport layer,
wherein the second electrode of each cell is electrically connected in series to the first electrode of a nearest cell.

2. The perovskite solar cell module of claim 1, wherein the second electrode of each cell is stacked on an upper surface of the second charge transport layer and in contact with the first electrode of the nearest cell, and is patterned to be separated from the second electrode of the nearest cell.

3. The perovskite solar cell module of claim 2, wherein each cell further comprises a functional layer stacked on at least one of positons between the second charge transport layer and the second electrode thereof, and between first charge transport layers, photoactive layers, and second charge transport layers patterned and separated so that the second electrode of each cell is in contact with the first electrode of the nearest cell, the functional layer being configured to block permeation of external moisture and oxygen.

4. The perovskite solar cell module of claim 3, wherein each cell further comprises a functional layer stacked on at least one of an upper surface of the second electrode thereof and between the second electrodes patterned and separated in neighboring cells.

5. The perovskite solar cell module of claim 3, wherein the second electrode of each cell is stacked on the upper surface of the second charge transport layer and in contact with the first electrode of the nearest cell, and
the first charge transport layer, the photoactive layer, the second charge transport layer, the functional layer, and the second electrode of each cell are patterned on the first electrode by etching to be separated from the first charge transport layer, the photoactive layer, the second charge transport layer, the functional layer, and the second electrode of the nearest cell.

6. The perovskite solar cell module of claim 5, wherein each cell further comprises a functional layer stacked on at least one of an upper surface of the second electrode thereof and between the first charge transport layers, the photoactive layers, the second charge transport layers, the functional layers, and the second electrodes patterned and separated in neighboring cells.

7. The perovskite solar cell module of claim 2, wherein each cell further comprises a functional layer stacked on at least one of an upper surface of the second electrode thereof and between the second electrodes patterned and separated in neighboring cells.

8. The perovskite solar cell module of claim 2, wherein the second electrode of each cell is stacked on the upper surface of the second charge transport layer and in contact with the first electrode of the nearest cell, and
the first charge transport layer, the photoactive layer, the second charge transport layer, and the second electrode of each cell are patterned on the first electrode by etching to be separated from the first charge transport layer, the photoactive layer, the second charge transport layer, and the second electrode of the nearest cell.

9. The perovskite solar cell module of claim 8, wherein each cell further comprises a functional layer stacked on at least one of an upper surface of the second electrode thereof and between the first charge transport layers, the photoactive layers, the second charge transport layers, and the second electrodes patterned and separated in neighboring cells.

10. A method of manufacturing the perovskite solar cell module of claim 1 in which a plurality of perovskite solar cells are disposed on a substrate, the method comprising
a first pattern forming step of sequentially stacking a first electrode, a first charge transport layer, a photoactive layer, and a second charge transport layer on the substrate, and patterning the first charge transport layer, the photoactive layer, and the second charge transport layer to separate each of the layers with predetermined spaces formed therein so that a second electrode of each cell is in contact with the first electrode of a nearest cell.

11. The method of claim 10, further comprising
a second pattern forming step of stacking a functional layer on an upper surface of the second charge transport layer of each cell and between the second charge transport layer and the second electrode of each cell, and partially patterning the functional layer to form predetermined spaces therein so that the second electrode of each cell is electrically connected in series to the first electrode of the nearest cell.

12. The method of claim 11, further comprising
a third pattern forming step of patterning the second electrode to form predetermined spaces therein so that the second electrode of each cell is separated from the second electrode of the nearest cell.
